# FASCICULE DE BREVET EUROPEEN

(11) **EP 2 324 085 B1**
(45) Date de publication et mention de la délivrance du brevet: **17.12.2014**
(21) Numéro de dépôt: 09772736.6
(22) Date de dépôt: 01.07.2009
(51) Int. Cl.: C25D 13/18, H01L 21/768, H01L 21/312, C25D 7/12

(54) **PROCEDE DE PREPARATION D'UN FILM ISOLANT ELECTRIQUE ET APPLICATION POUR LA METALLISATION DE VIAS TRAVERSANTS**
VERFAHREN ZUR HERSTELLUNG EINER ELEKTRISCH ISOLIERENDEN FOLIE UND VERWENDUNG ZUR METALLISIERUNG VON DURCHKONTAKTEN
PROCESS OF PREPARING AN ELECTRICAL ISOLATION FILM AND APPLICATION FOR THE METALLISATION OF THROUGH VIAS

(30) Priorité: 01.07.2008 FR 0854442
(43) Date de publication de la demande: 25.05.2011
(73) Titulaire: Alchimer, 91300 Massy (FR)
(72) Inventeur: MEVELLEC, Vincent, F-92100 Boulogne-Billancourt (FR); GONZALEZ, José, F-75019 Paris (FR); SUHR, Dominique, F-92290 Chatenay-Malabry (FR)
(74) Mandataire: Hubert, Philippe
(86) Numéro de dépôt international: PCT/FR2009/051279
(87) Numéro de publication internationale: WO 2010/001054

(56) Documents cités:
- WO-A-01/59178
- WO-A-2007/099137
- WO-A-2007/099218
- FR-A- 2 910 007

## Description

La présente invention concerne généralement un procédé pour revêtir en milieu protique une surface d'un substrat, notamment d'un substrat résistif à base de silicium, par une couche isolante susceptible d'être revêtue d'une couche barrière de diffusion au cuivre.

L'invention trouve essentiellement application dans le domaine de la microélectronique pour la métallisation notamment par du cuivre de vias traversants (dénommés « through silicon vias » ou « through wafer vias » ou « through wafer interconnect » en anglais) clef de voûte de l'intégration des puces électroniques (dénommées « chip » ou « die » en anglais) en trois dimensions (3D) ou intégration verticale. Elle trouve également application dans d'autres domaines de l'électronique où un substrat comportant des vias traversants doit être électriquement isolé et recouvert d'une couche de cuivre. On citera dans ce contexte la fabrication d'éléments d'interconnexion dans des circuits imprimés (dénommés « printed circuit board » ou « printed wire board » en anglais) ou celle d'éléments passifs, tels que les inductances, ou électromécaniques dans des circuits intégrés ou des microsystèmes (dénommés « micro electro mechanical systems » en anglais).

Les systèmes électroniques actuels se composent, pour la plupart, de plusieurs circuits intégrés, ou composants, et chaque circuit intégré remplit une ou plusieurs fonctions. Par exemple, un ordinateur comporte au moins un microprocesseur et plusieurs circuits mémoires. Chaque circuit intégré correspond usuellement à une puce électronique dans son propre boîtier (dénommé « package » en anglais). Les circuits intégrés sont brasés ou enfichés sur, par exemple, un circuit imprimé (dénommé « printed circuit board » ou « PCB » en anglais) qui assure la connexion entre les circuits intégrés.

Le besoin permanent d'augmenter la densité de fonctionnalité des systèmes électroniques a conduit selon une première approche au concept du « système sur puce » (dénommé « system on chip » en anglais), tous les composants et blocs de circuit nécessaires à la mise en oeuvre de l'ensemble des fonctions du système étant alors réalisés sur la même puce, sans utiliser le support d'un circuit imprimé. En pratique, il est néanmoins très difficile d'obtenir un « système sur puce » de haute performance car les procédés de fabrication des circuits logiques et mémoires, par exemple, diffèrent très substantiellement. L'approche « système sur puce » aboutit donc à consentir des compromis quant aux performances des différentes fonctions réalisées sur la même puce. De plus la taille de telles puces et leur rendement de fabrication atteignent les limites de leur faisabilité économique.

Une deuxième approche consiste à fabriquer dans un même boîtier un module assurant l'interconnexion de plusieurs circuits intégrés, lesquels peuvent alors provenir du même substrat semi-conducteur ou de substrats différents. Le boîtier ainsi obtenu ou « module multi puce » (dénommé « multi chip module » ou « MCM » en anglais) se présente ainsi sous la forme d'un composant unique. Cette approche « MCM » permet d'obtenir une plus haute densité d'interconnexion et donc une meilleure performance qu'une approche « PCB » classique. Néanmoins elle ne s'en distingue pas fondamentalement. Outre l'encombrement et le poids du boîtier, les performances d'un « MCM » restent limitées par les éléments parasites associés à la longueur des connexions du substrat et aux fils de connexion (dénommés « wire bonding » en anglais) reliant le substrat ou les puces aux broches (dénommées « pins » en anglais) du boîtier.

Une troisième approche dénommée "intégration en trois dimensions" (3D) ou "intégration verticale" se caractérise par le fait que les puces sont superposées et reliées entre elles par des interconnexions verticales. L'empilement obtenu comporte ainsi plusieurs couches ou strates de composants actifs ou puces, et constitue un circuit intégré en trois dimensions (dénommé « 3D integrated circuit » ou « 3D IC » en anglais).

Les bénéfices de l'intégration 3D relèvent à la fois :
(1) de l'amélioration des performances e.g. réduction du temps de propagation et de la puissance dissipée, augmentation de la rapidité de fonctionnement du système associée à la communication accélérée entre les blocs fonctionnels, augmentation de la bande passante de chaque bloc fonctionnel, augmentation de l'immunité au bruit,
(2) de l'amélioration des coûts e.g. augmentation de la densité d'intégration, meilleur rendement de fabrication grâce à l'emploi de la génération de puce électronique la plus appropriée à chaque bloc fonctionnel, amélioration de la fiabilité, et
(3) de la possibilité de réaliser des systèmes hautement intégrés par l'empilement de technologies hétérogènes (ou co-intégration) i.e. mettant en jeu différents matériaux et/ou différents composants fonctionnels.

De ce fait, l'intégration 3D constitue aujourd'hui une alternative indispensable aux approches conventionnelles, qui atteignent leurs limites en termes de performance, de diversification des fonctionnalités et de coût de réalisation. Les fondements et avantages de l'intégration 3D ont été décrits par exemple dans : A.W. Topol et al., "Three-dimensional integrated circuits" IBM Journal Res. & Dev., n°4/5 July/September 2006, 50, 491-506.

Après empilement, par exemple par collage, les puces peuvent être individuellement connectées aux broches du boîtier par des fils de connexion. L'interconnexion des puces entre elles est généralement réalisée par la mise en oeuvre de vias traversants.

Ainsi, les technologies élémentaires nécessaires à la réalisation de circuits intégrés en trois dimensions comprennent notamment l'amincissement des tranches de silicium (dénommées "wafers" en anglais), l'alignement entre les couches, le collage des couches, la gravure et la métallisation des vias traversants au sein de chaque couche.

L'amincissement des tranches de silicium peut être réalisée avant la fabrication des vias traversants (e.g. U.S. 7,060,624; U.S. 7,148,565).

Alternativement, la gravure et la métallisation des vias peuvent être réalisées avant amincissement de la tranche de silicium (e.g. U.S. 7,060,624; U.S. 7,101,792). Dans ce cas des vias fermés ou « borgnes » (dénommés « blind vias» en anglais) sont gravés dans le silicium, puis métallisés jusqu'à la profondeur souhaitée avant d'amincir la tranche de silicium, pour obtenir ainsi des vias traversants.

La bonne conductivité électrique du cuivre et sa résistance élevée au phénomène d'électromigration, c'est-à-dire la faible migration des atomes de cuivre sous l'effet de la densité de courant électrique susceptible d'être une cause importante de défaillance, en font en particulier un matériau de choix pour la métallisation des vias traversants.

Les vias traversants des circuits intégrés 3D sont généralement réalisés de façon similaire au « procédé Damascene » utilisé dans le domaine de la microélectronique pour la fabrication d'éléments d'interconnexion des circuits intégrés, selon une succession d'étapes comportant :
- la gravure des vias dans ou au travers de la tranche de silicium ;
- le dépôt d'une couche diélectrique isolante
- le dépôt d'une couche barrière ou « liner » servant à empêcher la migration ou diffusion du cuivre ;
- le remplissage des vias par électrodéposition de cuivre ; et
- l'élimination du cuivre en excès par polissage mécano-chimique.

La couche barrière, du fait de la résistivité élevée des matériaux qui la constituent, présente généralement une résistance trop élevée pour permettre, par voie électrochimique directe, un dépôt de cuivre homogène ou uniforme à l'échelle de la tranche, phénomène connu de l'homme de l'art sous le terme de chute ohmique.

Il est de ce fait nécessaire, préalablement à l'étape de remplissage par électrodéposition du cuivre, de recouvrir la couche barrière d'une mince couche de cuivre métallique, appelée couche de germination.

Cette couche de germination peut être réalisée de différentes manières : par des procédés de dépôt physique ou chimique à partir d'une phase vapeur (PVD ou "Physical Vapor Déposition" et CVD ou "Chemical Vapor Deposition" en anglais, respectivement), ou bien par dépôt en milieu liquide grâce à la technologie dite d'électrogreffage.

La couche diélectrique isolante peut être :
- soit de nature inorganique (oxyde de silicium SiO₂, nitrure de silicium Si₃N₄ ou oxyde d'aluminium par exemple),
- soit de nature organique (parylène C N ou D, polyimide, benzocyclobutène, polybenzoxazole par exemple).

Qu'elle soit de nature organique ou inorganique, la couche diélectrique isolante est le plus souvent déposée par voie sèche afin d'obtenir une couche isolante uniforme, dans les procédés connus de fabrication de vias traversants.

Ainsi, dans le document WO 2006/086337, il est préconisé de réaliser la couche diélectrique isolante, formée de préférence de parylène, par un procédé de dépôt en phase vapeur.

Les procédés utilisant un dépôt chimique en phase vapeur spécifiquement préconisés dans ce document antérieur sont relativement coûteux en raison du prix élevé des consommables (précurseurs) et surtout de l'équipement nécessaire à leur mise en oeuvre, ainsi que de leur faible rendement.

Les procédés utilisant un dépôt physique en phase vapeur également envisagés dans ce document antérieur ne permettent pas d'obtenir des revêtements d'une épaisseur uniforme en tout point de la surface des vias traversants de circuits intégrés en trois dimensions à haute densité dont les facteurs de forme sont généralement très importants.

Le brevet US 6 770 558 décrit un procédé de fabrication de vias traversants dans lequel la couche diélectrique isolante, de nature inorganique (SiO₂), est réalisée soit par oxydation thermique, soit par dépôt chimique en phase vapeur.

Il en résulte les mêmes inconvénients que ceux évoqués précédemment en relation avec le procédé décrit dans le document WO 2006/086337.

Pour éviter les problèmes liés aux procédés de dépôt par voie sèche, une solution possible réside dans l'utilisation d'un procédé de dépôt par voie humide.

Divers documents de l'état de la technique qui ne concernent pas directement la fabrication de vias traversants de circuits intégrés en trois dimensions décrivent des procédés de préparation d'un film organique à la surface d'un substrat qui peut être conducteur ou semiconducteur de l'électricité, faisant appel à l'électrogreffage d'un polymère. L'électrogreffage est une technique de dépôt par voie humide basée sur l'initiation puis la polymérisation, par propagation en chaîne, électro-induite de monomères électro-actifs sur la surface à recouvrir.

D'une façon générale, l'électrogreffage requiert :
- d'une part, l'utilisation d'une solution liquide contenant un composé initiateur et un monomère ; et
- d'autre part, un protocole électrochimique permettant la formation d'un film de polymère à la surface du substrat à revêtir.

Un tel procédé de préparation par électrogreffage d'un film organique est décrit par exemple dans la demande de brevet internationale WO 2007/099137. Ce procédé connu utilise :
- d'une part, une solution d'électrogreffage contenant au moins un sel de diazonium et un monomère polymérisable en chaîne ; et
- d'autre part, un protocole électrochimique de dépôt par voltampérométrie cyclique.

Les monomères polymérisables généralement utilisés dans ce document antérieur ne sont pas solubles en milieu protique, de sorte que la solution d'électrogreffage contient généralement un solvant aprotique comme notamment le diméthylformamide, dont l'utilisation pose des problèmes en terme environnemental.

Le document WO 2007/099218 décrit également un procédé de préparation par électrogreffage d'un film organique, dans lequel la solution liquide d'électrogreffage contient un solvant protique et au moins un amorceur de polymérisation par voie radicalaire soluble dans ce solvant protique.

Les monomères polymérisables utilisés selon ce document antérieur étant faiblement solubles en milieu protique, il est préconisé d'ajouter au moins un tensioactif à la solution d'électrogreffage afin de solubiliser le monomère polymérisable dans des micelles.

Cependant, l'utilisation de tensioactifs limite la concentration en monomère dans la solution d'électrogreffage à des valeurs trop faibles pour permettre une utilisation de ce procédé respectant les contraintes industrielles.

En outre, les tensioactifs utilisés sont susceptibles de s'adsorber sur la surface à revêtir et, par conséquent, de s'insérer dans le film organique formé sur le substrat. Il en résulterait une altération des propriétés isolantes du film ainsi préparé.

Par ailleurs, et comme dans le cas du document WO 2007/099137 discuté précédemment, il a été observé que l'utilisation d'un protocole d'électrogreffage utilisant la voltampérométrie cyclique ne permet pas une cinétique de croissance du film compatible avec les exigences industrielles.

Dans ces conditions, la présente invention a pour but de résoudre le problème technique consistant en la fourniture d'un nouveau procédé de préparation par électrogreffage d'un film organique à la surface d'un substrat conducteur ou semiconducteur de l'électricité, qui soit :
- adapté notamment à la formation d'un film isolant électrique dans la fabrication de vias traversants, en particulier de circuits intégrés en trois dimensions ;
- susceptible d'être mis en oeuvre par voie humide dans des conditions compatibles avec les contraintes industrielles, en conduisant à un dépôt continu et conforme pour une large gamme de facteurs de forme et présentant une excellente adhésion au substrat.

La présente invention a également pour but de résoudre le problème technique précité en permettant de réaliser un film isolant susceptible d'être lui-même recouvert par voie humide d'une couche formant barrière de diffusion du cuivre.

Il a été découvert, et ceci constitue le fondement de la présente invention, qu'il était possible de résoudre le problème technique précité d'une façon satisfaisante à l'échelle industrielle par la mise en oeuvre :
- d'une part, d'une solution d'électrogreffage de nature protique, et en particulier une solution aqueuse, dans laquelle le précurseur du film est choisi parmi les monomères solubles dans ce solvant ; et
- d'autre part, un protocole d'électrogreffage en mode pulsé permettant la formation d'un film continu et uniforme avec une cinétique de croissance compatible avec les contraintes industrielles.

Ainsi, selon un premier aspect, la présente invention concerne un procédé de préparation d'un film isolant électrique à la surface d'un substrat conducteur ou semiconducteur de l'électricité, tel qu'un substrat de silicium, caractérisé en ce qu'il comprend :
a) la mise en contact de ladite surface avec une solution liquide exempte de tensioactif comprenant :
   - un solvant protique ;
   - au moins un sel de diazonium ;
   - au moins un monomère polymérisable en chaîne et soluble dans ledit solvant protique ;
   - au moins un acide en une quantité suffisante pour stabiliser ledit sel de diazonium par ajustement du pH de ladite solution à une valeur inférieure à 7, de préférence inférieure à 2,5 ;
b) la polarisation de ladite surface selon un mode potentio- ou galvano-pulsé pendant une durée suffisante pour former un film présentant une épaisseur d'au moins 80 nanomètres, et de préférence comprise entre 100 et 500 nanomètres.

Avantageusement, le solvant protique utilisé dans le procédé précité est choisi dans le groupe constitué par l'eau, de préférence dé-ionisée ou distillée ; les solvants hydroxylés, en particulier les alcools ayant 1 à 4 atomes de carbone ; les acides carboxyliques ayant 2 à 4 atomes de carbone, en particulier l'acide formique et l'acide acétique et leurs mélanges.

L'eau constitue le solvant protique actuellement préféré dans le cadre de l'invention.

D'une façon générale, de nombreux sels de diazonium sont susceptibles d'être utilisés pour la mise en oeuvre du procédé selon ce premier aspect de l'invention, et en particulier les sels de diazonium cités dans le document WO 2007/099218.

Ainsi, selon une caractéristique particulière, le sel de diazonium est un sel d'aryle diazonium choisi parmi dans les composés de formule (I) suivante :

R-N₂⁺,A⁻ (I)

dans laquelle :
- A représente un anion monovalent,
- R représente un groupe aryle.

Comme exemple de groupe aryle R, on peut notamment citer les structures carbonées aromatiques ou hétéroaromatiques non substituées ou mono- ou polysubstituées, constituées d'un ou plusieurs cycles aromatiques ou hétéroaromatiques comportant chacun de 3 à 8 atomes, le ou les hétéroatomes étant choisi(s) parmi N, O, S, ou P ; le (ou les) substituant(s) éventuel(s) étant de préférence choisi(s) parmi les groupements attracteurs d'électrons tels que NO₂, COH, les cétones, CN, CO₂H, NH₂, les esters et les halogènes.

Les groupes R particulièrement préférés sont les groupes nitrophényle et phényle.

Au sein des composés de formule (I) ci-dessus, A peut notamment être choisi parmi les anions inorganiques tels que les halogénures comme I⁻, Br⁻ et Cl⁻, les halogénoboranes tels que le tétrafluoroborane, et les anions organiques tels que les alcoolates, les carboxylates, les perchlorates et les sulfates.

Selon un mode de réalisation préféré de l'invention, le sel de diazonium de formule (I) précitée est choisi parmi le tétrafluoroborate de phényldiazonium, le tétrafluoroborate de 4-nitrophényldiazonium, le tétrafluoroborate de 4-bromophényldiazonium, le chlorure de 2-méthyl-4-chlorophényldiazonium, le tétrafluoroborate de 4-benzoylbenzènediazonium, le tétrafluoroborate de 4-cyanophényldiazonium, le tétrafluoroborate du 4-carboxyphényldiazonium, le tétrafluoroborate de 4-acétamidophényldiazonium, le tétrafluoroborate de l'acide 4-phénylacétique diazonium, le sulfate de 2-méthyl-4-[(2-méthylphényl)-diazényl]benzènediazonium, le chlorure de 9,10-dioxo-9,10-dihydro-1-anthracènediazonium, le tétrafluoroborate de 4-nitrophtalènediazonium, et le tétrafluoroborate de naphtalènediazonium, le chlorure de 4-aminophényldiazonium.

De manière préférentielle, le sel de diazonium sera choisi parmi le tétrafluoroborate de phényldiazonium et le tétrafluoroborate de 4-nitrophényldiazonium.

Le sel de diazonium est généralement présent au sein de la solution liquide d'électrogreffage en une quantité comprise entre 10⁻³ et 10⁻¹ M, de préférence entre 5.10⁻³ et 3.10⁻² M.

D'une façon générale, la solution d'électrogreffage contient au moins un monomère polymérisable en chaine et soluble dans le solvant protique.

Le choix d'un monomère soluble dans le solvant protique constitue une caractéristique essentielle et originale de l'invention.

Par "soluble dans un solvant protique", on entend désigner ici tout monomère ou mélange de monomères dont la solubilité dans le solvant protique est au moins de 0,5 M.

L'homme du métier n'aura aucune difficulté pour choisir les monomères susceptibles d'être utilisés dans le cadre de la présente invention.

Ces monomères seront avantageusement choisis parmi les monomères vinyliques solubles dans le solvant protique et répondant à la formule générale (II) suivante : 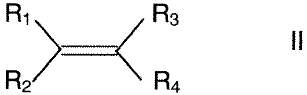 dans laquelle les groupes R₁ à R₄, identiques ou différents, représentent un atome monovalent non métallique tel qu'un atome d'halogène ou un atome d'hydrogène, ou un groupe chimique saturé ou insaturé, tel qu'un groupe alkyle en C₁-C₆, aryle, un groupe -COOR₅ dans lequel R₅ représente un atome d'hydrogène ou un groupe alkyle en C₁-C₆, nitrile, carbonyle, amine ou amide.

D'une façon préférentielle, on utilisera les monomères solubles dans l'eau. De tels monomères seront avantageusement choisis parmi les monomères éthyléniques comportant des groupements pyridine comme la 4-vinylpyridine ou 2-vinylpyridine, ou parmi les monomères éthyléniques comportant des groupements carboxyliques comme l'acide acrylique, l'acide méthacrylique, l'acide itaconique, l'acide maléique, l'acide fumarique et leurs sels sodiques, potassiques, ammoniacaux ou d'amine, les amides de ces acides carboxyliques et en particulier, l'acrylamide et le méthacrylamide ainsi que leurs dérivés N-substitués, leurs esters tels que le 2-hydroxyéthyl méthacrylate, le méthacrylate de glycidyle, le diméthyl ou le diéthyl amino (éthyl ou propyl) (méth) acrylate et leurs sels, les dérivés quaternisés de ces esters cationiques comme, par exemple, le chlorure d'acryloxyéthyl triméthylammonium, l'acide 2-acrylamido-2-méthylpropane sulfonique (AMPS), l'acide vinylsulfonique, l'acide vinylphosphorique, l'acide vinyllactique et leurs sels, l'acrylonitrile, la N-vinylpyrrolidone, l'acétate de vinyle, le N-vinylimidazoline et ses dérivés, le N- vinylimidazole et les dérivés du type diallylammonium comme le chlorure de diméthyldiallylammonium, le bromure de diméthyldiallylammonium, le chlorure de diéthyldiallylammonium.

La composition quantitative de la solution liquide d'électrogreffage peut varier dans de larges limites.

D'une façon générale, cette solution comprend :
- au moins 0.3 M de monomère(s) polymérisable(s),
- au moins 5.10⁻³ M de sel(s) de diazonium,
le rapport molaire entre le(s) monomère(s) polymérisable(s) et le(s) sel(s) de diazonium étant compris entre 10 et 300.

Comme mentionné précédemment, l'utilisation d'un protocole d'électrogreffage en mode puisé constitue une autre caractéristique essentielle et originale de l'invention, dans la mesure où ce protocole particulier permet de façon tout à fait inattendue et à la différence d'un protocole d'électrogreffage en voltampérométrie cyclique d'obtenir un film continu et uniforme avec une cinétique de croissance compatible avec les contraintes industrielles.

D'une façon générale, la polarisation de la surface à recouvrir par le film est réalisée selon un mode pulsé dont chaque cycle est caractérisé par :
- une période totale P comprise entre 10 ms et 2 s, de préférence de l'ordre de 0,6 s ;
- un temps de polarisation Tₒₙ compris entre 0,01 et 1 s, de préférence de l'ordre de 0,36 s durant lequel une différence de potentiel ou un courant est imposé à la surface du substrat ; et
- un temps de repos à potentiel ou courant nul d'une durée comprise entre 0,01 et 1 s, de préférence de l'ordre de 0,24 s.

Le procédé de préparation d'un film isolant électrique qui vient d'être décrit est notamment utile dans la préparation de vias traversants, en particulier de circuits intégrés en trois dimensions, pour constituer la couche électrique isolante interne destinée à être revêtue de la couche barrière servant à empêcher la migration ou la diffusion du cuivre.

Avantageusement, la couche barrière précitée est elle-même réalisée par un procédé de dépôt par voie humide, de préférence dans un milieu liquide de nature protique pour des raisons que l'on comprend aisément.

Dans ce contexte, il a été découvert, et ceci constitue une originalité de l'invention, que la couche barrière servant à empêcher la migration ou la diffusion du cuivre peut être avantageusement constituée d'un film métallique à base de nickel ou de cobalt.

Ainsi, selon un deuxième aspect, l'invention concerne un procédé de préparation d'un revêtement d'un substrat conducteur ou semiconducteur de l'électricité, ledit revêtement étant constitué d'une première couche formant un film isolant électrique et une deuxième couche formant barrière de diffusion du cuivre, caractérisé en ce que :
A. ladite première couche est réalisée par la mise en oeuvre du procédé décrit précédemment
B. ladite deuxième couche est réalisée par :
   a) la formation par voie humide à la surface de la première couche ainsi obtenue d'un film organique contenant des particules, notamment des nanoparticules de métaux ou d'alliages métalliques en particulier de nickel ou de cobalt ;
   b) la mise en contact du film ainsi formé avec une solution liquide contenant au moins un sel métallique, de préférence de même nature que le métal incorporé dans le film organique, et au moins un agent réducteur dans des conditions permettant la formation d'un film métallique présentant une épaisseur d'au moins 100 nm.

Selon un premier mode de réalisation de l'invention, l'étape B.a) précitée est réalisée par la mise en contact de la surface libre de la couche interne précitée avec une solution liquide comprenant :
- au moins un solvant, de préférence protique ;
- au moins un sel de diazonium ;
- au moins un monomère polymérisable en chaîne et soluble dans ledit solvant ;
- au moins un amorceur chimique permettant la formation d'entités radicalaires à partir dudit sel de diazonium.

Le solvant protique et le sel de diazonium mis en oeuvre dans l'étape B.a) précitée peuvent être de même nature que les composés correspondant utilisés à l'étape A.

L'utilisation d'un solvant aprotique, tel que par exemple la diméthylformamide, l'acétone ou le diméthylsulfoxyde, peut néanmoins être envisagée dans le cadre de la mise en oeuvre de l'étape B.a).

Le monomère polymérisable en chaîne par voie radicalaire peut être de nature variée.

Il sera notamment choisi parmi les monomères décrits dans le document WO 2007/099218.

D'une façon préférentielle, on utilisera également les monomères solubles dans l'eau qui ont été décrits en relation avec l'étape A.

L'amorceur chimique susceptible d'être utilisé pour permettre la formation d'entité radicalaire à partir du sel de diazonium sera généralement choisi parmi un métal réducteur sous forme finement divisée ou une base organique ou inorganique dans les proportions suffisantes pour que le pH de la solution liquide soit supérieur ou égal à 4.

De façon préférée dans le cadre de l'invention, l'amorceur chimique est un métal réducteur choisi parmi le fer, le zinc ou le nickel, sous une forme finement divisée tel que par exemple de la limaille.

La composition quantitative de la solution liquide utilisée à l'étape B.a) peut varier dans de larges limites.

D'une façon générale, cette solution comprend :
- au moins 0.3 M de monomère(s) polymérisable(s),
- au moins 5.10⁻² M de sel(s) de diazonium,

Comme on le comprend, l'étape B.a) permet la formation d'un film organique dans des conditions non électrochimiques particulièrement intéressantes sur le plan environnemental.

Selon l'invention, le film organique ainsi obtenu est traité pour contenir des particules, notamment des nanoparticules, de métaux ou d'alliages métalliques, en particulier de nickel ou de cobalt.

A cet effet, ce film est mis en contact avec une suspension contenant lesdites particules.

Comme on le comprend, la nature du monomère utilisé pour la préparation du film organique à l'étape B.a) et la nature des particules seront choisies de telle sorte que le film obtenu à l'étape B.a) et lesdites particules présentent une affinité physico-chimique suffisante pour lier lesdites particules audit film et permettre une métallisation ultérieure.

D'une façon générale, les particules contenues dans le film organique seront constituées de métaux ou d'alliages métalliques, ces métaux pouvant être choisis notamment parmi les métaux nobles et les métaux de transition, ainsi que leurs alliages. Ces métaux peuvent être alliés à des éléments tels que le phosphore ou le bore ou un mélange de ces composés.

Avantageusement, on utilisera des particules de nickel ou de cobalt alliées au bore.

Ces particules se présenteront de préférence sous la forme de nanoparticules présentant de préférence une taille moyenne inférieure à 25 nanomètres et de préférence encore inférieure à 10 nanomètres.

D'une façon générale, l'incorporation des particules sera réalisée à l'aide d'une suspension colloïdale de ces particules.

Dans le cas particulier de nanoparticules de nickel alliées à du bore, cette suspension peut être réalisée par réaction, en présence d'un agent stabilisant de type surfactant (A. Roucoux et al., Adv. Synth. & Catal., 2003, 345, 222-229) tel que le bromure de cétyltriméthylammonium, entre un précurseur métallique, tel que le sulfate de nickel, et un réducteur tel que le borohydrure de sodium permettant la synthèse de particules métalliques zérovalentes sous forme colloïdale.

Les particules présentes dans le film organique obtenu à l'étape B.a) permettent la préparation ultérieure d'un revêtement métallique par un procédé non électrochimique généralement dénommé "électroless" (R.C. Agarwala et al., Sadhana, parts 3&4 June/August 2003, 28, 475-493).

A cet effet, le film organique contenant les particules métalliques est mis en contact avec une solution liquide contenant :
- au moins un sel métallique, de préférence de même nature que le métal incorporé dans le film organique ;
- un agent stabilisant, et
- au moins un agent réducteur,
dans des conditions permettant la formation d'un film métallique présentant une épaisseur d'au moins 100 nanomètres.

Avantageusement, le sel métallique précité peut être choisi dans le groupe constitué par l'acétate, l'acétylacétonate, l'hexafluoro-phosphate, le nitrate, le perchlorate, le sulfate, ou le tétrafluoroborate du métal précité.

Avantageusement, l'agent réducteur précité peut être choisi dans le groupe constitué par l'acide hypophosphoreux et ses sels, les dérivés du borane (NaBH₄, DMAB), le glucose, le formaldéhyde et l'hydrazine.

Avantageusement, l'agent stabilisant précité est choisi dans le groupe constitué par l'éthylènediamine, un acétate, un succinate, un malonate, un aminoacétate, un malate ou un citrate de métal alcalin.

Selon un deuxième mode de réalisation du procédé de préparation selon le deuxième aspect de l'invention, dans le cas où le monomère polymérisable en chaîne utilisé à l'étape A.a) est une vinylpyridine, de préférence la 4-vinylpyridine, l'étape B.a) est réalisée par la mise en contact de la surface libre de la couche interne de polyvinylpyridine avec une solution liquide comprenant :
- au moins un solvant, de préférence protique ;
- au moins un polymère soluble dans ledit solvant et comportant des groupes fonctionnels susceptibles de se lier par liaisons hydrogène ou de Van der Waals avec les groupes fonctionnels de la polyvinylpyridine ; ledit polymère étant choisi parmi les polymères contenant une ou plusieurs fonctions choisie(s) parmi les fonctions hydroxyle, amine (primaire ou secondaire), ammonium, acide carboxylique, sels d'acide carboxylique, anhydride carboxylique (cyclique ou linéaire), amide : C(=O)NHR où R représente un atome d'hydrogène ou un groupe alkyle ayant 1 à 6 atomes de carbone, amino-acide, acide phosphonique, sels d'acide phosphonique, acide phosphorique, sels d'acide phosphorique, acide sulfonique, sels d'acide sulfonique, acide sulfurique, sels d'acide sulfurique, acide succinimique, sels d'acide succinimique, phtalimide, sels de phtalimide, Si(OH)ₙ où n est un nombre entier compris entre 1 et 3 ;
pendant une durée suffisante pour permettre la formation desdites liaisons hydrogène ou de Van der Waals.

De préférence, le solvant protique utilisé sera l'eau et le polymère sera un polymère soluble dans l'eau.

Selon un mode de réalisation actuellement préféré de l'invention, le monomère polymérisable en chaîne utilisé à l'étape A.a) est la 4-vinylpyridine et le polymère soluble utilisé à l'étape B.a) est un polyacide acrylique.

Le procédé de préparation d'un revêtement bicouche (isolant/couche barrière) qui vient d'être décrit est notamment utile dans la préparation de vias traversants, notamment de circuits intégrés, pour constituer la structure interne destinée à être revêtue d'une couche de germination du cuivre permettant la métallisation des vias traversants.

Avantageusement, la couche de germination du cuivre précitée est elle-même réalisée par un procédé de dépôt par voie humide, de préférence dans un milieu liquide.

Ainsi, selon un troisième aspect, l'invention concerne un procédé de préparation d'un revêtement d'un substrat conducteur ou semiconducteur de l'électricité, ledit revêtement étant constitué d'une première couche interne formant film isolant électrique obtenue selon l'étape A. décrite précédemment, d'une deuxième couche intermédiaire formant barrière de diffusion du cuivre obtenue selon l'étape B. décrite précédemment, et d'une troisième couche externe de germination de cuivre, laquelle couche est réalisée par :
C. a) la mise en contact de la surface libre de la deuxième couche avec une solution liquide comprenant :
   - au moins un solvant ;
   - des ions de cuivre en une concentration comprise entre 14 et 120 mM ;
   - de l'éthylènediamine ;
   - le rapport molaire entre l'éthylènediamine et le cuivre étant compris entre 1,80 et 2,03 ;
   - le pH de ladite composition étant compris entre 6,6 et 7,5 ;
   b) la polarisation de ladite surface libre de la deuxième couche pendant une durée suffisante pour former ladite troisième couche.

Comme on le comprend, l'étape C. permet de réaliser la métallisation de vias traversants.

Il a été montré que les solutions liquides mises en oeuvre dans l'étape C. permettent d'obtenir de façon tout à fait surprenante, une couche de germination de cuivre conduisant à un taux de couverture du substrat particulièrement élevé (supérieur à 99 %) y compris dans les zones les plus critiques des vias et ce même lorsque la structure présente un facteur de forme élevé (rapport d'aspect supérieur à 3:1, voire de l'ordre de 10 à 15:1) et un volume de via relativement élevé (de 0,8.10¹ à 5.10⁶ µm³). Ces solutions liquides sont donc parfaitement compatibles avec une utilisation à l'échelle industrielle.

Une famille préférée de solutions liquides mises en oeuvre dans l'étape C. comprend celles dont les ions de cuivre sont présents en une concentration comprise entre 16 et 64 mM.

Une autre famille préférée de solutions liquides mises en oeuvre dans l'étape C. comprend celles dont le rapport molaire entre les ions de cuivre et l'éthylènediamine est compris entre 1,96 et 2,00.

Bien qu'il n'y ait pas de restriction de principe sur la nature du solvant (pourvu qu'il solubilise suffisamment les espèces actives de la solution et n'interfère pas avec l'électrodéposition), il s'agira de préférence d'eau.

D'une façon générale, la solution liquide mise en oeuvre dans l'étape C. comprend une source d'ions du cuivre, en particulier d'ions cuivriques Cu²⁺.

Avantageusement, la source d'ions du cuivre est un sel de cuivre tel qu'en particulier le sulfate de cuivre, le chlorure de cuivre, le nitrate de cuivre, l'acétate de cuivre, de préférence le sulfate de cuivre, et de préférence encore le sulfate de cuivre pentahydraté.

Selon une caractéristique particulière, les ions du cuivre sont présents au sein de la solution liquide mise en oeuvre dans l'étape C. en une concentration comprise entre 14 et 120 mM ; de préférence entre 16 et 64 mM.

D'excellents résultats ont été obtenus avec des solutions liquides dans lesquelles la source d'ions du cuivre est présente en une concentration comprise entre 16 et 32 mM.

Dans la solution liquide mise en oeuvre dans l'étape C., le rapport molaire entre les ions du cuivre et l'éthylènediamine est compris entre 1,80 et 2,03, de préférence entre 1,96 et 2,00.

D'une façon générale, la solution liquide mise en oeuvre dans l'étape C. présente un pH compris entre 6,6 et 7,5. Cette valeur est normalement atteinte lorsque la solution liquide mise en oeuvre dans l'étape C. est constituée uniquement d'ions du cuivre et d'éthylènediamine dans les proportions mentionnées précédemment.

Le pH de la solution liquide mise en oeuvre dans l'étape C. peut éventuellement être ajusté dans la gamme de pH précitée au moyen d'un tampon tel que l'un de ceux décrits dans : « Handbook of chemistry and physics - 84th édition » David R. Lide, CRC Press, dans le cas où la solution liquide mise en oeuvre dans l'étape C. comporte des composés autres que la source d'ions du cuivre et l'éthylènediamine.

Une solution liquide mise en oeuvre dans l'étape C. actuellement préférée, selon l'invention, comprend, en solution aqueuse :
- des ions de cuivre, en une concentration comprise entre 16 et 64 mM ;
- de l'éthylènediamine ;
- le rapport molaire entre l'éthylènediamine et les ions de cuivre étant compris entre 1,96 et 2,00 ;
- le pH de ladite composition étant compris entre 6,6 et 7,5.

Les solutions liquides précitées peuvent être mises en oeuvre dans un procédé usuel d'électrodéposition comportant la mise en contact de la surface d'un substrat, tel qu'en particulier une couche barrière de diffusion au cuivre d'une structure de type « via traversant », avec une solution liquide mise telle que définie précédemment et une étape de formation d'un revêtement sur ladite surface du substrat au cours de laquelle ladite surface est polarisée pendant une durée suffisante pour former ledit revêtement.

Il a été observé, de façon surprenante, que d'excellents résultats en la matière peuvent être obtenus à l'aide d'une solution liquide en contrôlant, lors du procédé d'électrodéposition mis en oeuvre dans l'étape C., les conditions de mise en contact de la surface à revêtir avec ladite solution liquide préalablement à la formation du revêtement.

Il a été observé, de façon tout à fait inattendue, qu'il était possible d'améliorer l'adhérence entre la couche de revêtement de cuivre réalisée par électrodéposition et la couche barrière, en mettant la surface à revêtir au contact de la solution liquide mise en oeuvre dans l'étape C. sans polarisation électrique, c'est-à-dire sans imposer de courant électrique ou de potentiel électrique par rapport à une contre-électrode ou par rapport à une électrode de référence à cette surface, préalablement à l'étape d'électrodéposition.

Une amélioration encore plus importante de cette adhérence a été observée lorsque la surface du substrat à revêtir est maintenue au contact de la solution liquide mise en oeuvre dans l'étape C. (par exemple par immersion dans la composition d'électrodéposition) pendant une durée d'au moins 1 minute, par exemple de l'ordre de 3 minutes toujours préalablement à l'étape d'électrodéposition.

Il a été constaté que l'amélioration de l'adhérence de la couche de germination sur la couche barrière permet également d'améliorer l'adhésion de l'ensemble « couche de germination / couche de remplissage ou cuivre épais ou couche épaisse », c'est-à-dire l'adhérence « opérationnelle » de l'assemblage pour lequel la couche de germination est réalisée.

On peut par exemple évaluer cette adhésion par pelage (« peeling » en anglais) d'un ruban adhésif collé sur la surface supérieure de l'assemblage par exemple par l'emploi d'une machine d'essai ou de traction. L'adhésion ainsi mesurée, ou énergie d'interface exprimée en J.m⁻², caractérise globalement à la fois l'adhérence de la couche de germination sur la barrière et celle de la couche épaisse de cuivre sur la couche de germination.

Il n'y a pas de restriction de principe sur l'étape de séparation du substrat revêtu de la couche de germination de cuivre après la formation du revêtement.

Il a été observé, qu'il était possible par exemple d'obtenir une couche de germination présentant une conductivité compatible avec les procédés de remplissage de vias par électrodéposition traditionnelle, en maintenant sous polarisation électrique la surface revêtue, de préférence pendant une durée comprise entre 1 et 10 secondes, de préférence pendant une durée comprise entre 1 et 5 secondes après sa séparation de la solution liquide mise en oeuvre dans l'étape C.

Ainsi, les solutions liquides mises en oeuvre dans l'étape C. seront de préférence mises en oeuvre dans un procédé d'électrodéposition comprenant :
- une étape dite « d'entrée à froid » au cours de laquelle ladite surface à revêtir est mise en contact sans polarisation électrique avec la solution liquide d'électrodéposition et de préférence maintenue dans cet état pendant une durée d'au moins 1 minute ;
- une étape de formation du revêtement au cours de laquelle ladite surface est polarisée pendant une durée suffisante pour former ledit revêtement ;
- une étape dite de « sortie à chaud » au cours de laquelle ladite surface est séparée de la solution liquide d'électrodéposition tandis qu'elle est encore sous polarisation électrique.

Dans ce procédé, l'étape de formation du revêtement par électrodéposition est conduite pendant une durée suffisante pour former le revêtement souhaité. Cette durée peut être facilement déterminée par l'homme du métier, la croissance du film étant fonction de la charge qui est égale à l'intégrale temporelle du courant électrique passé dans le circuit pendant le temps du dépôt (loi de Faraday).

Au cours de l'étape de formation du revêtement, la surface à revêtir peut-être polarisée, soit en mode galvanostatique (courant imposé fixe), soit en mode potentiostatique (potentiel imposé et fixe, éventuellement par rapport à une électrode de référence), soit encore en mode pulsé (en courant ou en tension).

D'une façon générale, il a été observé qu'un revêtement particulièrement satisfaisant peut être obtenu par polarisation en mode pulsé, de préférence de manière à imposer des créneaux de courant.

D'une façon générale, cette étape peut être réalisée en imposant des créneaux de courant correspondants à un courant par unité de surface maximum dans une gamme de 0,6 mA.cm⁻² à 10 mA.cm⁻², et plus particulièrement de 1 mA.cm⁻² à 5 mA.cm⁻² et à un courant par unité de surface minimum dans une gamme de 0 mA.cm⁻² à 5 mA.cm⁻², et de préférence de 0 mA.cm⁻².

Plus particulièrement, la durée de polarisation au courant maximum peut être comprise entre 2.10⁻³ et 1,6 secondes, de préférence entre 0,1 et 0,8 seconde, par exemple de l'ordre de 0,35 seconde, tandis que la durée de polarisation au courant minimum peut être comprise entre 2.10⁻³ et 1,6 secondes, de préférence entre 0,1 et 0,8 seconde, par exemple de l'ordre de 0,25 seconde.

Le nombre de cycles à réaliser au cours de cette étape dépend de l'épaisseur souhaitée du revêtement.

D'une façon générale l'homme du métier déterminera aisément le nombre de cycles à réaliser sachant que dans les conditions préférentielles précitées, il a été observé que la vitesse de dépôt est d'environ 0,3 nm par seconde.

Ce mode de mise en oeuvre de l'étape C. a permis de réaliser des couches de germination de cuivre présentant une épaisseur comprise entre 50 nm et 1 µm sur des substrats très résistifs de structures de type « via traversant », dont la résistance carrée peut atteindre 1000 ohm/carré, voire même quelques méga ohm/carré.

La présente invention couvre donc un procédé de revêtement d'une surface d'un substrat, tel qu'en particulier la surface d'une couche barrière de diffusion au cuivre d'une structure de type « via traversant », qui comprend la mise en contact de ladite surface avec une solution liquide mise en oeuvre dans l'étape C. telle que décrite précédemment et une étape au cours de laquelle ladite surface est polarisée pendant une durée suffisante pour former ledit revêtement.

Cette étape C. de revêtement est particulièrement utile pour la réalisation d'une couche de germination de cuivre présentant une épaisseur pouvant être de l'ordre de 50 nm à 1 µm, de préférence de 200 à 800 nm, par exemple de l'ordre de 300 nm, sur la surface d'une barrière de diffusion au cuivre telle qu'obtenue par la mise en oeuvre des étapes A. et B. dans une structure de type « via traversant ».

Les procédés qui viennent d'être décrits permettent la fabrication de tranches de matériaux conducteurs ou semiconducteurs, notamment en silicium, d'une structure nouvelle.

Ainsi, selon un dernier aspect, l'invention a pour objet :
- une tranche d'un matériau conducteur ou semiconducteur, notamment en silicium, comportant un ou plusieurs vias, caractérisée en ce que les parois de chaque via sont recouvertes d'une couche interne en poly-4-vinylpyridine (P4VP) d'une épaisseur comprise entre 200 et 400 nanomètres formant isolant électrique, elle-même recouverte d'une couche de nickel éventuellement allié au bore, d'une épaisseur comprise entre 100 et 300 nanomètres formant barrière de diffusion au cuivre, elle-même recouverte d'une couche de cuivre d'une épaisseur comprise entre 200 et 500 nanomètres formant couche de germination ; et
- une tranche d'un matériau conducteur ou semiconducteur, notamment en silicium, comportant un ou plusieurs vias, caractérisée en ce que les parois de chaque via sont recouvertes d'une couche interne en poly-2-hydroxyéthyl méthacrylate (PHEMA) d'une épaisseur comprise entre 200 et 400 nanomètres formant isolant électrique, elle-même recouverte d'une couche de nickel éventuellement au bore d'une épaisseur comprise entre 100 et 300 nanomètres formant barrière de diffusion au cuivre, elle-même recouverte d'une couche de cuivre d'une épaisseur comprise entre 200 et 500 nanomètres formant couche de germination.

### EXEMPLES

L'invention sera mieux comprise à la lecture de la description des exemples non limitatifs suivants faite en référence aux figures annexées qui représentent respectivement :
**Fïgure 1:** Représentation schématique d'un protocole pulsé d'électrogreffage utilisable conformément à l'invention.
**Figure 2** : Spectre Infrarouge ATR-IR d'un film de P4VP sur Si dopé N obtenu à l'exemple 1.
**Figure 3** **:** Microscopie Electronique à Balayage d'un film de P4VP sur Si dopé N obtenu à l'exemple 1.
**Figure 4** **:** Microscopie Electronique à Balayage d'un film de P4VP sur Si dopé P obtenu à l'exemple 2.
**Figure 5** : Microscopie Electronique à Balayage d'un film de P4VP dans des vias 30 x 60 µm creusés dans du silicium dopé P et obtenu à l'exemple 3.
**Figure 6** **:** Spectre Infrarouge ATR-IR d'un film de PHEMA sur Si dopé N obtenu à l'exemple 4.
**Figure 7** **:** Microscopie Electronique à Balayage d'un film de PHEMA sur Si dopé N obtenu à l'exemple 4.
**Figure 8****:** Microscopie Electronique à Balayage d'un film de PHEMA dans des vias 75 x 200 µm creusés dans du silicium dopé P+ obtenu à l'exemple 6.
**Figure 9** **:** Microscopie Electronique à Balayage d'un film de P4VP sur lequel à été déposée une couche de PAA et des nanoparticules métalliques obtenu à l'exemple 7, 2ème étape.
**Fïgure 10** : Microscopie Electronique à Balayage d'un empilement P4VP-PAA-NiB sur Si dopé N obtenu à l'exemple 7, 3ème étape.
**Figure 11**: Microscopie Electronique à Balayage d'un film de PHEMA électrogreffé sur lequel à été déposée une couche de PHEMA et des nanoparticules métalliques obtenu à l'exemple 8, 2ème étape.
**Figure 12****:** Microscopie Electronique à Balayage d'un empilement PHEMA-PHEMA-NiB dans des vias 75 x 200 µm creusés dans du silicium dopé P+ obtenu à l'exemple 8, 3ème étape.
**Figure 13** **:** Microscopie Electronique à Balayage d'un empilement P4VP-PHEMA-NiB dans des vias 30 x 60 µm creusés dans du silicium dopé P obtenu à l'exemple 9.
**Figure 14** **:** Microscopie Electronique à Balayage d'un empilement P4VP-PHEMA-NiB-Cu dans des vias 30 x 60 µm creusés dans du silicium dopé P obtenu à l'exemple 10.
**Figure 15** **:** Profil Tof-SIMS en épaisseur réalisé sur un empilement P4VP-PHEMA-NiB-Cu obtenu à l'exemple 10, avant recuit (échantillon brut) et après recuit à 400°C pendant 2 heures sous gaz inerte.
**Figure 16** : Microscopie Electronique à Balayage d'un empilement P4VP-PHEMA-NiB-Cu dans des vias 30 x 90 µm creusés dans du silicium dopé P obtenu à l'exemple 11.

Les exemples qui suivent ont été réalisés à l'échelle du laboratoire.

Sauf indication contraire, ces exemples ont été réalisés dans des conditions normales de température et de pression (environ 25°C sous environ 1 atm) à l'air ambiant, et les réactifs utilisés ont été directement obtenus dans le commerce sans purification supplémentaire.

Les substrats utilisés présentent une surface à revêtir généralement constituée de silicium, éventuellement dopé par des éléments variés (N, P, P+) pris en différents pourcentages.

Dans certains cas, et plus particulièrement avec certains substrats dopés P, les surfaces de silicium seront avantageusement soumises à un traitement préalable consistant en un trempage dans une solution piranha (H₂SO₄:H₂O₂ 5:1 v/v) suivi d'un trempage dans une solution d'acide fluorhydrique (10% v/v).

Les substrats de silicium utilisés dans ces exemples présentaient des valeurs de résistivité comprises entre 1 et 100 Ω.cm.

### Exemple 1 - Préparation d'un film de poly-4-vinylpyridine (P4VP) sur un substrat plan silicium dopé N.

### Substrat :

Le substrat utilisé dans cet exemple est un coupon de silicium dopé N de 4 cm de côté (4 x 4 cm) et de 750 µm d'épaisseur ayant une résistivité de 20 Ω.cm.

### Solution :

La solution d'électrogreffage mise en oeuvre dans cet exemple est une solution aqueuse préparée en introduisant 5 ml de 4-vinylpyridine (4-VP ; 4,5.10⁻² mol) dans 95 ml d'HCl 1 M, puis en ajoutant au mélange ainsi constitué 236 mg de 4-nitrobenzène diazonium tétrafluoroborate (DNO2 ; 1.10⁻³ mol).

La solution a été dégazée pendant 10 minutes préalablement à son utilisation, par un flux d'argon.

### Protocole :

Pour réaliser l'électrogreffage sur le substrat de silicium on a utilisé un système composé :
- d'un porte échantillon équipé de moyens de mise en rotation à vitesse prédéterminée et conformé pour supporter le substrat, l'ensemble ainsi constitué étant destiné à servir d'électrode de travail ;
- d'une feuille de carbone destinée à servir de contre électrode ;
- d'une alimentation électrique stabilisée et d'un dispositif de mise en contact électrique.

L'électrogreffage de la P4VP sur la surface du substrat de silicium a été réalisé en imposant au substrat, préalablement mis en rotation à une vitesse de 40 à 100 tr.min⁻¹ (60 tr.min⁻¹ dans l'exemple), un protocole électrochimique "potentio-pulsé" pendant une durée prédéterminée de l'ordre de 10 à 30 minutes (15 minutes dans l'exemple).

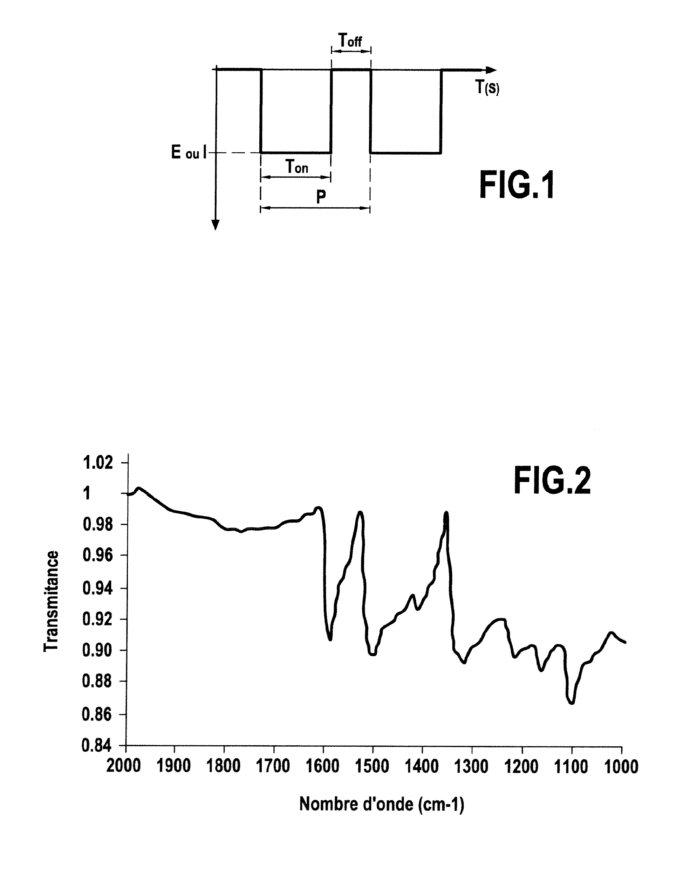

La **figure 1** illustre le protocole électrochimique qui a été utilisé, avec :
- une période totale P comprise entre 0,01 et 2 secondes (0,6 seconde dans l'exemple) ;
- un temps de polarisation Tₒₙ compris entre 0,01 et 1 seconde (0,36 seconde dans l'exemple) durant lequel une différence de potentiel de 5 V à 20 V est imposée à la surface du substrat (potentiel cathodique de -17 V dans l'exemple) ; et
- un temps de repos à potentiel nul noté T_{off} d'une durée comprise entre 0,01 et 1 seconde (0,240 seconde dans l'exemple).

La durée de cette étape d'électrogreffage dépend, comme on le comprend, de l'épaisseur souhaitée de la couche isolante de polymère. Cette durée peut être facilement déterminée par l'homme du métier, la croissance de la couche étant fonction de la différence de potentiel appliquée.

Dans les conditions précitées, on a obtenu une couche de polymère (P4VP) présentant une épaisseur de 300 nanomètres.

Une fois l'électrogreffage terminé, l'échantillon a été rincé plusieurs fois à l'eau puis au diméthylformamide (DMF) avant d'être séché sous courant d'argon puis à l'étuve pendant 2 heures (90°C). Le séchage de l'échantillon peut également être effectué sous atmosphère inerte et à des températures plus élevées, typiquement entre 100 et 200°C, afin d'obtenir un matériau le plus anhydre possible.

### Caractérisations :

L'échantillon ainsi préparé a été analysé par spectroscopie infrarouge et par spectroscopie de masse d'ions secondaires à temps de vol (ToF-SIMS).

Comme le montre le spectre infrarouge obtenu (voir **figure 2**), la présence des bandes d'adsorption à 1580 cm⁻¹ (P4VP), 1520 cm⁻¹ (diazonium) et 1350 cm⁻¹ (diazonium) confirme la présence de polymère (P4VP) électrogreffé sur la surface du silicium.

Les pics caractéristiques de la P4VP observés lors de l'analyse ToF-SIMS en ions positifs sont reportés dans le **tableau 1.**

**Tableau 1 : Pics caractéristiques du dépôt P4VP sur Si dopé N observés par spectroscopie de masse d'ions secondaires à temps de vol (ToF-SIMS) en ions positifs.**

| **Ion** | C₂H₆N | C₅H₅N | C₅H₆N | C₆H₇N | C₇H₈N | C₉H₈N | C₁₄H₁₅N₂ |
|---|---|---|---|---|---|---|---|
| **Ct Mass** | 44 | 79 | 80 | 93 | 106 | 130 | 211 |

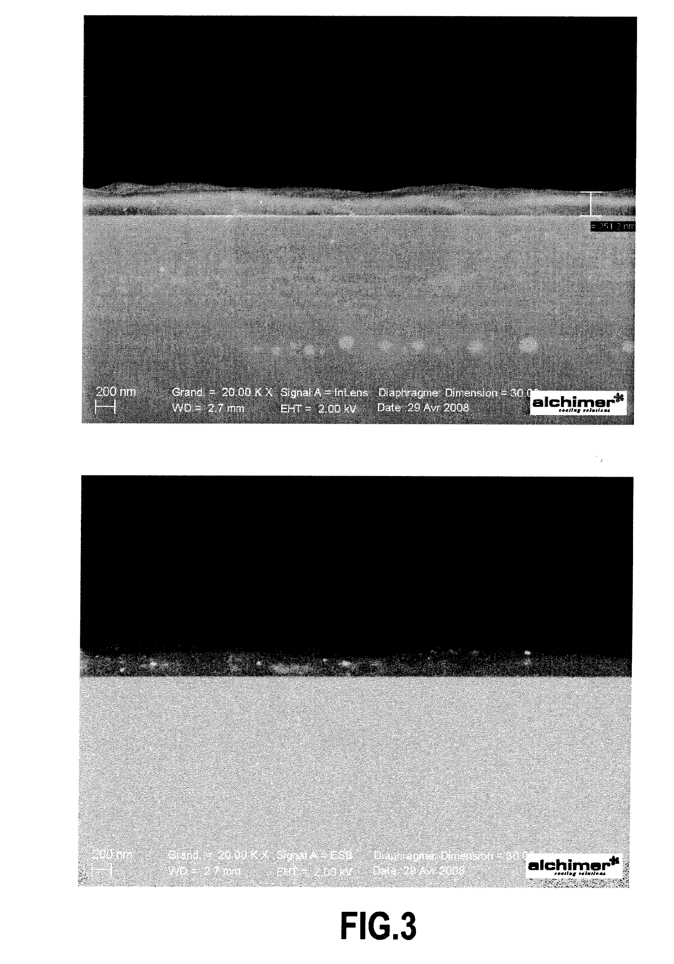

Une analyse en microscopie électronique à balayage (MEB) (voir **figure 3**) a permis également de visualiser la présence d'un film homogène de polymère sur la surface de l'échantillon de silicium.

Le caractère isolant du film de polymère obtenu a été analysé par mesure C(V) (Capacitance-Voltage). Les résultats obtenus sont regroupés dans le **tableau 2.**

**Tableau 2 : Mesures électriques obtenues sur des films de P4VP et PHEMA.**

| **Polymère** | **Indice de réfraction** | **Tension de claquage (MV/cm)** | **Constante diélectrique** | **Résistivité (µΩ.cm)** |
|---|---|---|---|---|
| P4VP | 1,5 | 1,66 | 4,95 | 2,6.10¹⁴ |
| PHEMA | 0,98 | 1,43 | 1,89 | 4,38.10¹³ |

Les valeurs obtenues confirment le fort caractère isolant des revêtements de P4VP ainsi formés.

### Exemple 2 - Préparation d'un film de poly-4-vinylpyridine (P4VP) sur un substrat plan silicium dopé P.

### Substrat :

Le substrat utilisé dans cet exemple est un coupon de silicium dopé P de 4 cm de côté (4 x 4 cm) et de 750 µm d'épaisseur ayant une résistivité de 20 Ω.cm.

### Solution :

Identique à celle utilisée dans l'exemple 1.

### Protocole :

Le protocole expérimental est identique au protocole décrit à l'exemple 1, avec l'utilisation additionnelle d'une source lumineuse (lampe halogène, 150 W) placée devant l'échantillon de silicium dopé P, de façon à obtenir le maximum d'intensité lumineuse sur la surface de l'échantillon. La lampe est placée pour cela à une distance d'environ 10 cm de la surface de l'échantillon. L'échantillon est éclairé pendant toute la durée de l'expérience.

Le protocole électrochimique pulsé décrit dans l'exemple 1 est utilisé en appliquant une différence de potentiel de 1 V à 10 V (potentiel cathodique de -3 V dans l'exemple)

### Caractérisations :

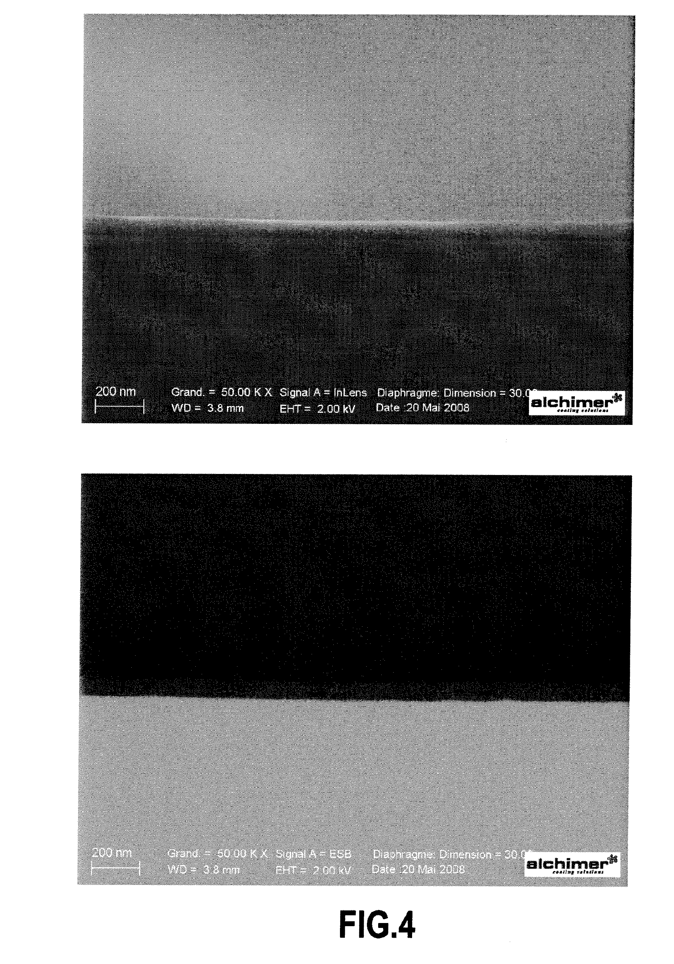

Une analyse en microscopie électronique à balayage (MEB), (voir **figure 4**), permet de visualiser la présence d'un film homogène de polymère sur la surface de l'échantillon de silicium dopé P.

### Exemple 3 - Préparation d'un film de poly-4-vinylpyridine (P4VP) sur une surface de silicium dopé P de vias traversants.

### Substrat :

Le substrat utilisé dans cet exemple est constitué d'une plaque de silicium de 4 cm de côté (4 x 4 cm) et de 750 µm d'épaisseur ayant une résistivité comprise entre 3 Ω.cm et 26 Ω.cm, gravée avec des motifs cylindriques de type « via traversant » de 60 µm de profondeur et de 30 µm de diamètre.

### Solution :

Identique à celle utilisée dans l'exemple 1

### Protocole :

Dans un premier temps, l'échantillon est placé dans la solution d'électrogreffage sous ultrasons pendant 30 secondes afin de permettre un bon remplissage des vias.

Le protocole est ensuite identique à celui décrit dans l'exemple 2.

### Caractérisations :

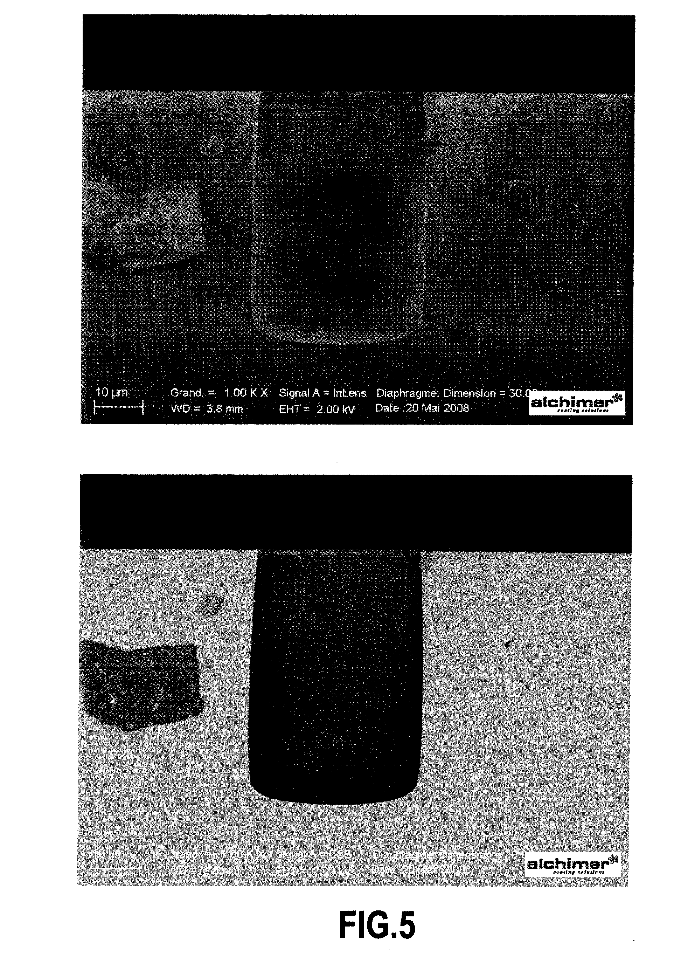

Une analyse en microscopie électronique à balayage (MEB) a permis de mettre en évidence la couverture des vias. La **figure 5** permet de visualiser la couverture complète d'un via par le film de P4VP électrogreffé.

Le film obtenu présente une bonne conformité. Le pourcentage de conformité du dépôt est calculé en rapportant l'épaisseur de la couche électrogreffée sur les surfaces verticales (profil ou flanc) du via à celle sur les surfaces horizontales en haut du via. L'épaisseur sur les surfaces verticales est mesurée à une profondeur du via donnée (4 µm au dessus du fond du via). Le pourcentage de conformité obtenu dans ces conditions est voisin de 50 %.

### Exemple 4 - Préparation d'un film de poly-2-hydroxyethyl méthacrylate (PHEMA) sur un substrat plan silicium dopé N.

### Substrat :

Identique à celui utilisé dans l'exemple 1.

### Solution :

La solution d'électrogreffage mise en oeuvre dans cet exemple est une solution aqueuse préparée en additionnant 30 ml de 2-hydroxyéthyl méthacrylate (HEMA ; 0,24 mol) dans 70 ml d'H₂SO₄ 0,1 N, puis en ajoutant au mélange ainsi constitué 236 mg de 4-nitrobenzène diazonium tétrafluoroborate (DNO₂; 1.10⁻³ mol).

La solution a été dégazée pendant 10 minutes, préalablement à son utilisation, par un flux d'argon.

### Protocole :

Identique à celui décrit dans l'exemple 1, un potentiel cathodique de -20 V ayant été appliqué dans l'exemple.

### Caractérisations :

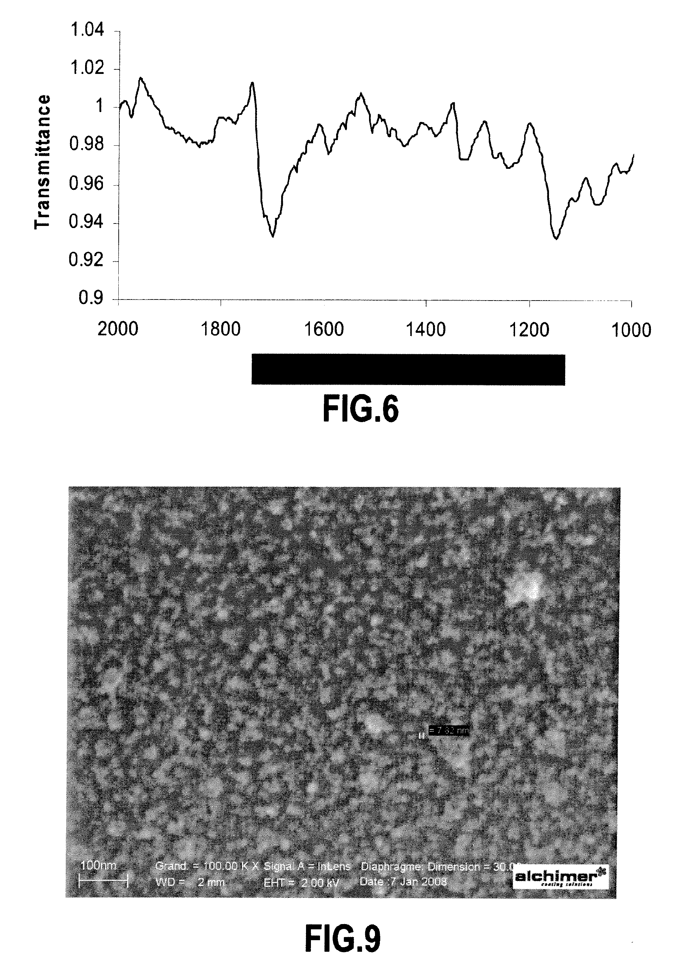

L'échantillon obtenu a été analysé par spectroscopie infrarouge, et le spectre infrarouge obtenu (**figure 6**) montre la présence des bandes d'adsorption à 1720 cm⁻¹ (PHEMA), 1520 cm⁻¹ (diazonium) et 1350 cm⁻¹ (diazonium) qui confirme la présence du film de polymère électrogreffé sur la surface de l'échantillon de silicium.

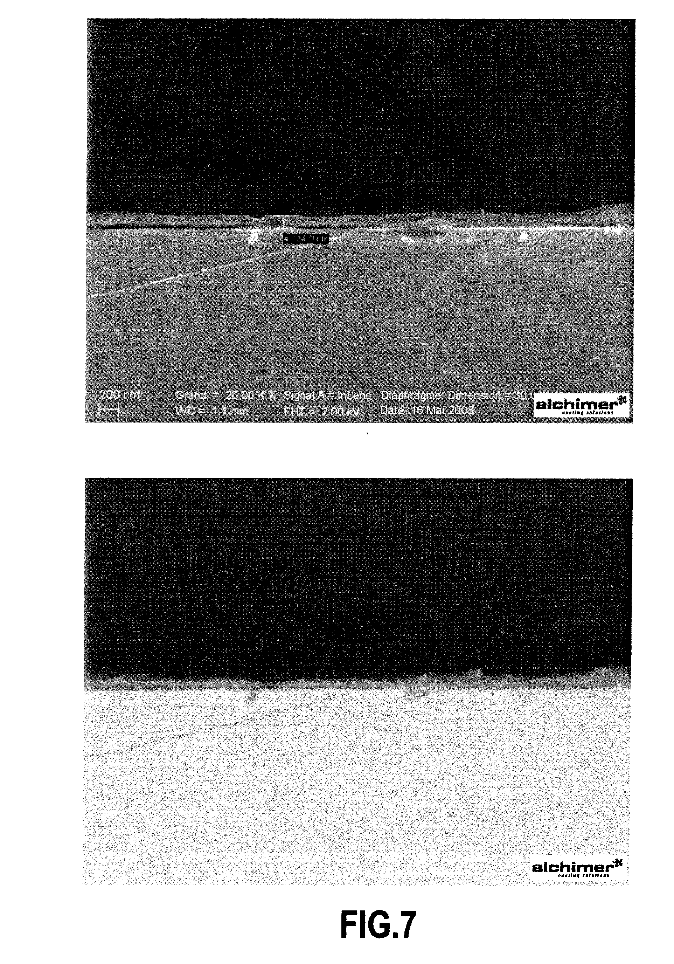

Une analyse en microscopie électronique à balayage (MEB) (voir **figure 7**) a permis également de visualiser la présence d'un film homogène de polymère sur la surface de l'échantillon de silicium.

Les mesures électriques effectuées sur le film de PHEMA sont reportées dans le **tableau 2** qui précède. Les valeurs obtenues confirment le fort caractère isolant des revêtements de PHEMA ainsi formés.

### Exemple 5 - Préparation d'un film de poly-2-hydroxyéthyl méthacrylate (PHEMA) sur un substrat plan silicium dopé P.

### Substrat :

Identique à celui utilisé dans l'exemple 2.

### Solution :

Identique à celle utilisée dans l'exemple 4.

### Protocole :

Identique à celui utilisé dans l'exemple 2.

### Caractérisations :

L'échantillon obtenu a été analysé par spectroscopie infrarouge, et le spectre infrarouge montre bien la présence des bandes caractéristiques du film de polymère électrogreffé sur la surface du silicium.

### Exemple 6 - Préparation d'un film de poly-2-hydroxyéthyl méthacrylate (PHEMA) sur une surface de silicium dopé P+ de vias traversants.

### Substrat :

Le substrat utilisé dans cet exemple est constitué d'une plaque de silicium de 4 cm de côté (4 x 4 cm) et de 750 µm d'épaisseur ayant une résistivité comprise entre 8 mΩ.cm et 20 mΩ.cm, gravée avec des motifs cylindriques de type « via traversant » de 200 µm de profondeur et de 75 µm de diamètre.

### Solution :

Identique à celle utilisée dans l'exemple 4.

### Protocole :

Identique à celui utilisé dans l'exemple 2.

### Caractérisations :

L'échantillon obtenu a été analysé par spectroscopie infrarouge, et le spectre infrarouge confirme la présence de polymère (PHEMA) électrogreffé sur la surface de l'échantillon de silicium.

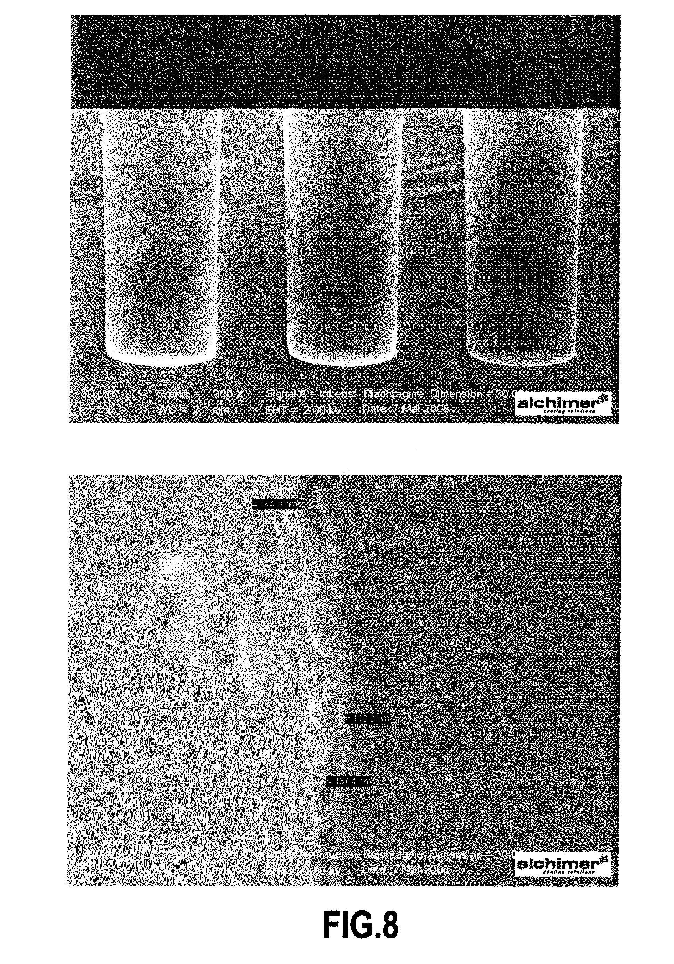

Une analyse en microscopie à balayage (MEB) (voir **figure 8**) a permis de visualiser la présence d'un film homogène de polymère couvrant la totalité de la surface du via. Le pourcentage de conformité du dépôt, tel que mesuré dans l'exemple 3, est de 40 %.

### Exemple 7 - Réalisation d'un empilement isolant/barrière P4VP-PAA-NIB sur un substrat plan silicium dopé N.

### Substrat :

Identique à celui utilisé dans l'exemple 1.

### Isolation :

Réalisée selon l'exemple 1.

### Barrière de diffusion :

Une barrière de Nickel-Bore (NiB) est déposée en trois étapes sur la surface de poly-4-vinylpyridine (P4VP) obtenue à l'issue de l'exemple 1.

### Etape 1 : Formation d'une couche d'accroche polymérique de type polyacide :

### Solution :

La solution mise en oeuvre dans cet exemple est une solution aqueuse d'acide polyacrylique (PAA ; MW 450000 ; 1 g.l⁻¹).

### Protocole :

Le substrat revêtu du film de P4VP obtenu à l'exemple 1 est immergé pendant 10 minutes dans un bécher contenant la solution aqueuse d'acide polyacrylique. L'échantillon est ensuite lavé plusieurs fois à l'eau distillée puis séché sous courant d'argon.

### Caractérisations :

L'échantillon ainsi obtenu a été analysé par spectroscopie de masse d'ions secondaires à temps de vol (ToF-SIMS). L'analyse ToF-SIMS dont les résultats sont reportés au **tableau 3** a permis de mettre en évidence les pics caractéristiques du PAA.

**Tableau 3: Pics caractéristiques du PAA sur un empilement SiN/P4VP/PAA observés par spectroscopie de masse d'ions secondaires à temps de vol (ToF-SIMS) en ions négatifs.**

| **Ion** | C₂H₃O₂ | C₃H₃O₃ | C₆H₇O₂ | C₆H₉O₂ | CH₇O₄ | C₉H₈N | C₁₀H₁₅O₅ |
|---|---|---|---|---|---|---|---|
| **Ct Mass** | 51 | 71 | 111 | 113 | 143 | 130 | 215 |

### Etape 2 : Incorporation de nanoparticules de NiB :

### Solution :

Une suspension colloïdale de nanoparticules de NiB à été préparée à 20°C. A cet effet, 120 mg d'un précurseur métallique NiSO₄ (4,5.10⁻⁴ mol) ont été dissous dans 50 ml d'eau dé-ionisée puis 1,8 g de stabilisant bromure de cétyltriméthylammonium (CTAB ; 4,7.10⁻³ mol) a été ajouté. A cette solution ont été ajoutés, en une seule injection, 80 mg de borohydrure de sodium (NaBH₄ ; 2.10⁻³ mol) dissous dans 2 ml d'eau dé-ionisée. La solution a changé instantanément de couleur pour devenir noire intense caractéristique du métal zéro présent sous forme colloïdale.

### Protocole :

Le substrat revêtu en surface par une bicouche polymérique P4VP-PAA préparé à l'étape précédente a été introduit dans la solution colloïdale de NiB. L'échantillon a été maintenu dans cette solution pendant quelques minutes, par exemple entre 1 et 15 minutes, puis rincé à l'eau dé-ionisée pendant 1 minute environ avant d'être séché sous courant d'argon.

### Caractérisations :

Une analyse en microscopie électronique à balayage (MEB) (voir **figure 9**) a permis de visualiser la distribution des nanoparticules de NiB sur la surface du polymère.

### Etape 3 : Formation d'une couche de nickel par dépôt electroless :

### Solution :

La solution mise en oeuvre dans cet exemple a été préparée en introduisant dans un bécher en pyrex 50 ml d'eau dé-ionisée, 1,41 g de NiSO₄ (5,4.10⁻³ mol), 3g de citrate de sodium tribasique (1.10⁻² mol) ou 2 g d'acide citrique (1.10⁻² mol) et 141 mg de diméthyle aminoborane (DMAB ; 2.10⁻³ mol). Le pH de la solution a été ajusté à 9 par ajout d'une solution de soude NaOH ou de TMAH.

### Protocole :

La solution a été chauffée à 60°C, puis l'échantillon préparé à l'étape précédente a été introduit dans le milieu pendant quelques minutes, par exemple entre 2 et 10 minutes. Le substrat a ensuite été retiré puis rincé à l'eau dé-ionisée et séché sous courant d'argon.

### Caractérisations :

La surface ainsi traitée se caractérise par un aspect métallique uniforme (miroir). En fonction du temps de métallisation, les épaisseurs de métal obtenues peuvent varier entre quelques nanomètres et plusieurs centaines de nanomètres.

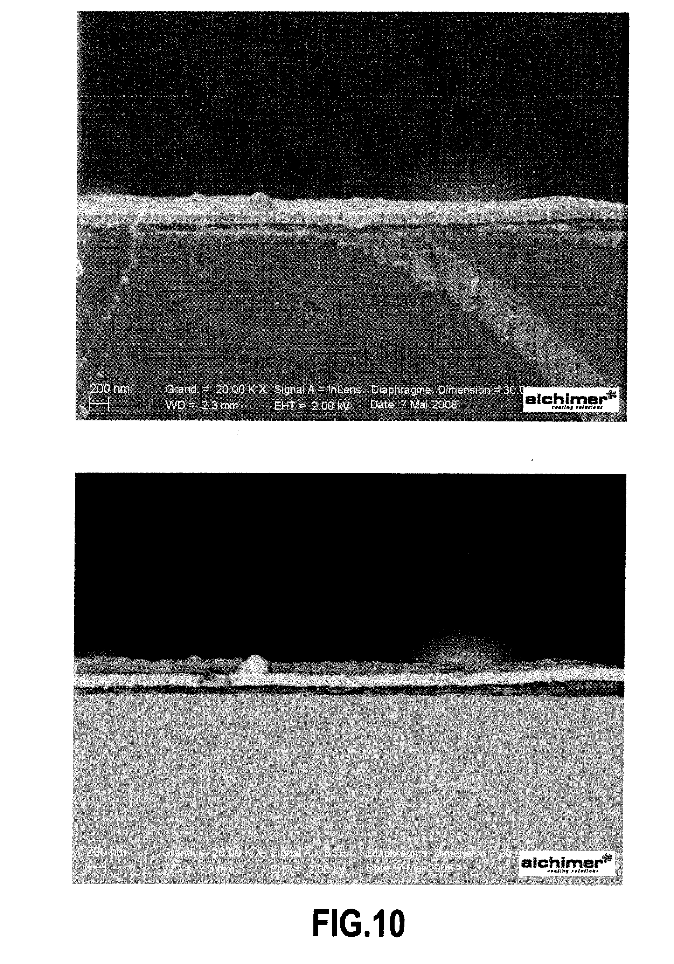

Une analyse en microscopie électronique à balayage (MEB) (voir **figure 10**) a permis de mettre en évidence la formation d'un film métallique de NiB continu sur toute la surface.

### Exemple 8 - Réalisation d'un empilement isolant/barrière PHEMA-PHEMA-NIB sur une surface de silicium dopé P+ de vias traversants.

### Substrat :

Identique à celui utilisé dans l'exemple 6.

### Isolation :

Réalisée selon l'exemple 6.

### Barriére de diffusion :

Une barrière de Nickel-Bore (NiB) a été déposée en trois étapes sur la surface de poly-2-hydroxyéthyl méthacrylate (PHEMA) obtenue à l'issue de l'exemple 6.

### Etape 1 : Formation d'une couche d'accroche formée d'un primaire d'adhésion

Cette couche a été réalisée en suivant l'enseignement général de la publication Mévellec et al.. Chem. Mater., 2007, 19, 6323-6330 :

### Solution :

La solution mise en oeuvre dans cet exemple est une solution aqueuse de primaire d'adhésion. Pour son élaboration, les solutions suivantes sont d'abord préparées :
- 1.08 g (1.10⁻² mol) de p-amino-aniline dans 100 ml de HCl 0.5 M (solution A).
- 690 mg (1.10⁻² mol) de NaNO₂ dans 100 ml d'eau dé-ionisée (solution B).
25 ml de la solution B sont additionnés lentement à 25 ml de la solution A. A ce mélange sont ensuite ajoutés 5 ml de 2-hydroxyéthyl méthacrylate (HEMA ; 4.10⁻² mol), puis la réaction est amorcée par ajout de 1 g de poudre de Fer à 99% (1,7.10⁻² mol) ou de 16 ml d'acide hypophosporeux commercial à 50 % en masse dans l'eau, agissant comme réducteur.

### Protocole :

Le substrat de silicium fonctionnalisé par le PHEMA obtenu à l'exemple 6 a été immergé dans la solution pendant une durée comprise entre 1 et 20 minutes, avant d'être lavé (DMF, eau) puis séché sous courant d'azote.

### Etape 2 : Incorporation de nanoparticules de NiB :

### Solution :

Identique à celle utilisée dans l'exemple 7, étape 2.

### Protocole :

Identique à celui utilisé dans l'exemple 7, étape 2.

### Caractérisations :

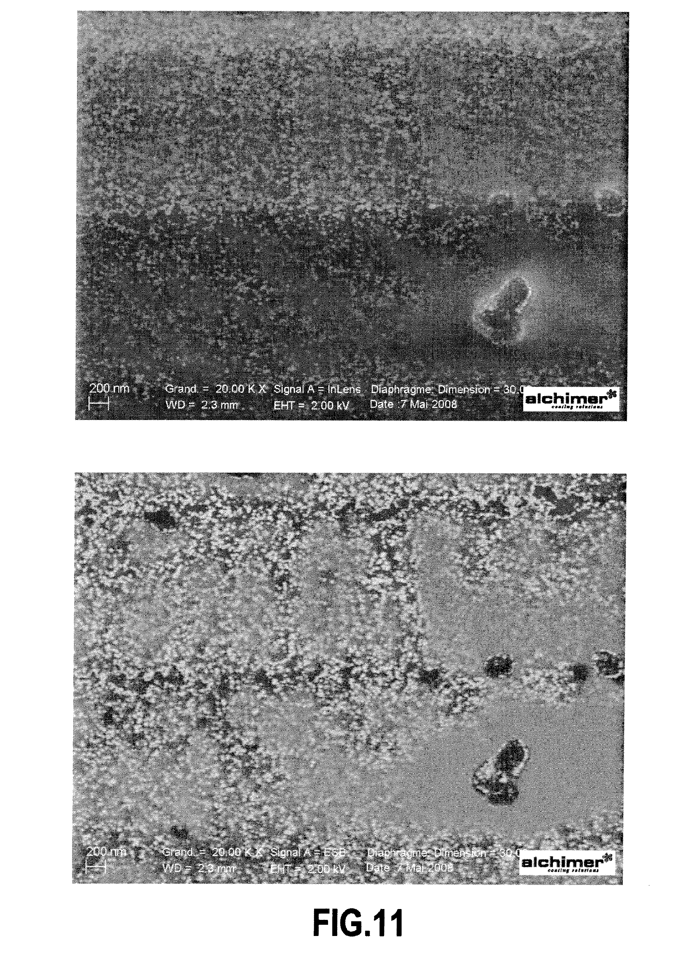

Une analyse en microscopie électronique à balayage (MEB) (voir **figure 11**) a permis de visualiser la distribution des nanoparticules de NiB sur la surface du polymère.

### Etape 3 : Formation d'une couche de nickel par dépôt electroless :

### Solution :

Identique à celle utilisée dans l'exemple 7, étape 3.

### Protocole :

Identique à celui utilisé dans l'exemple 7, étape 3.

### Caractérisations :

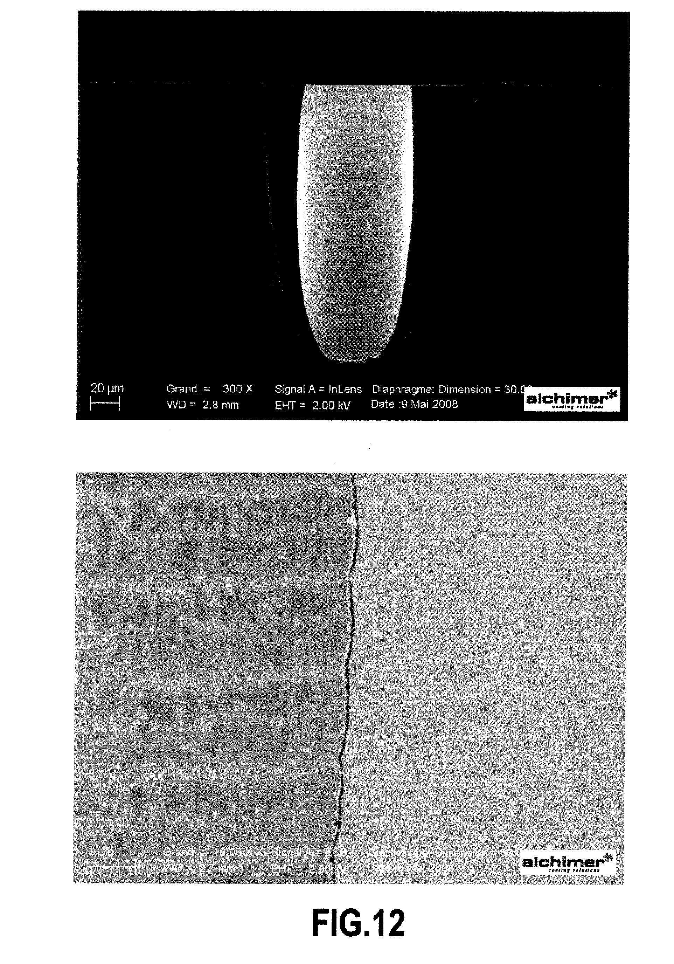

La surface ainsi traitée se caractérise par un aspect métallique uniforme (miroir). En fonction du temps de métallisation, les épaisseurs de métal obtenues peuvent varier entre quelques nanomètres et plusieurs centaines de nanomètres.
Une analyse en microscopie électronique à balayage (MEB) (voir **figure 12**) a permis de mettre en évidence la formation d'un film métallique de NiB continu sur toute la surface. Le pourcentage de conformité du dépôt de NiB, tel que mesuré dans l'exemple 3, est de 50 %.

**Exemple 9 - Réalisation d'un empilement isolant/barrière P4VP-PHEMA-NIB sur une surface de silicium dopé P de vias traversants.**

### Substrat :

Identique à celui utilisé dans l'exemple 3.

### Isolation :

Réalisée selon l'exemple 3.

### Barrière de diffusion :

Réalisée selon l'exemple 8.

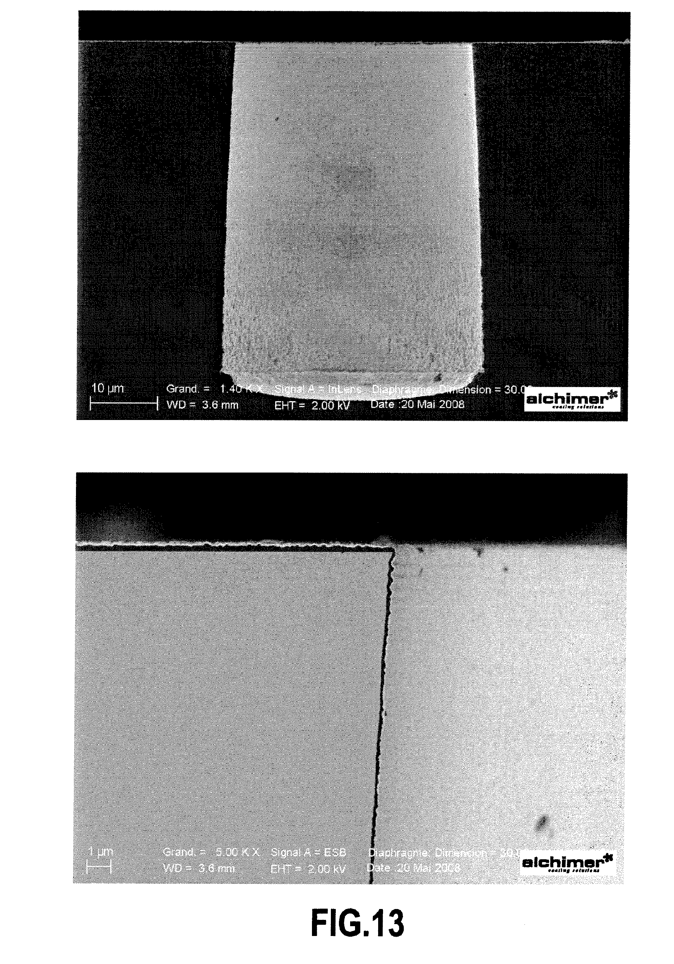

Une analyse en microscopie électronique à balayage (MEB) a permis de mettre en évidence l'empilement isolant/barrière sur la totalité de la surface du via (voir **figure 13**). Le pourcentage de conformité du dépôt, tel que mesuré dans l'exemple 3, est de 65 %.

### Exemple 10 - Réalisation d'un empilement isolant/barrière/couche de germination P4VP-PHEMA-NIB-Cu sur une surface de silicium dopé P de vias traversants.

### Substrat :

Identique à celui de l'exemple 3.

### Isolation :

Réalisée selon l'exemple 3.

### Barrière de diffusion :

Réalisée selon l'exemple 8.

### Formation d'une couche de germination de cuivre :

### Solution :

Le dépôt d'une couche de germination de cuivre à été réalisé en utilisant une solution aqueuse d'électrodéposition contenant 2,1 ml.l⁻¹ (32 mM) d'éthylènediamine et 4 g.l⁻¹ (16 mM) de CuSO₄(H₂O)₅.

### Protocole :

Le procédé d'électrodéposition mis en oeuvre dans cet exemple comporte différentes étapes consécutives :
- une étape « d'entrée à froid » où le substrat est mis en contact par trempage, sans être alimenté électriquement, avec la solution d'électrodéposition pendant une durée d'au moins une minute (par exemple 3 minutes).
- une étape de croissance du cuivre où le substrat est polarisé cathodiquement en mode galvano-pulsé et simultanément mis en rotation à une vitesse de 20 à 100 tours par minute (40 tours par minute par exemple). La **figure 1** décrit en détail le protocole galvano-pulsé susceptible d'être utilisé, avec une période totale P comprise entre 10 ms et 2 s (0,6 s dans l'exemple), un temps de polarisation T_{ON} compris entre 2 ms et 1,6 s (0,35 s dans l'exemple) en imposant un courant par unité de surface généralement compris entre 0,6 mA.cm⁻² et 10 mA.cm⁻² (2,77 mA.cm⁻² dans l'exemple), un temps de repos T_{off} sans polarisation compris entre 2 ms et 1,6 s (0,25 s dans l'exemple). La durée de cette étape dépend, comme on le comprend, de l'épaisseur souhaitée de la couche de germination. Cette durée peut être facilement déterminée par l'homme du métier, la croissance du film étant fonction de la charge passée dans le circuit. Dans les conditions précitées, la vitesse de dépôt est d'environ 1,5 nm par Coulomb de charge passée dans le circuit, ce qui donne une durée de l'étape d'électrodéposition de l'ordre de 17 minutes pour obtenir un revêtement ayant une épaisseur de 300 nm.
- une étape « de sortie à chaud » où le substrat revêtu de cuivre est retiré de la solution d'électrodéposition à vitesse de rotation nulle en étant maintenu sous polarisation en tension. La durée de cette phase est d'environ 2 secondes. La vitesse de rotation est alors portée à 500 tours par minute pendant 10 secondes, la polarisation cathodique étant coupée pendant cette dernière phase. Le substrat est alors rincé à l'eau dé-ionisée et séché sous balayage d'azote.

### Caractérisations :

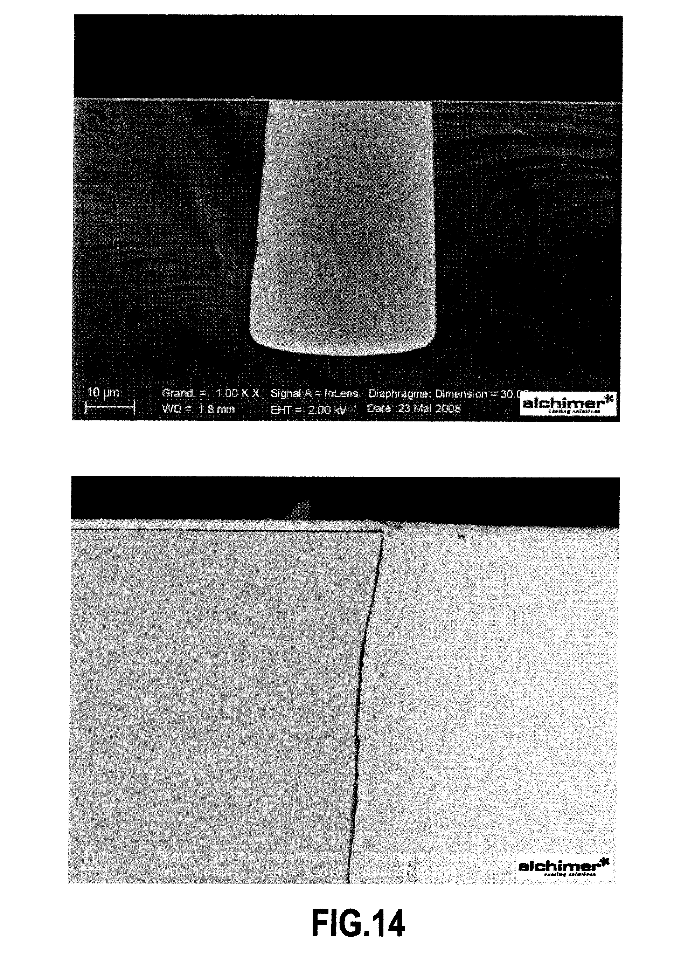

Une analyse en microscopie électronique à balayage (MEB) (voir **figure 14**) a permis de mettre en évidence l'empilement des trois couches isolant/barrière/cuivre sur la totalité de la surface du via. Le pourcentage de conformité de la couche de cuivre, tel que mesuré dans l'exemple 3, est de 60 %.

Les propriétés barrière de la couche de NiB ont été mises en évidence par un méthode analytique bien connue (M.Yoshino et al., Electrochim. Acta, 2005, 51, 916-920), qui consiste à suivre par profil Tof-SIMS en épaisseur la diffusion du cuivre dans la barrière de diffusion après recuit.

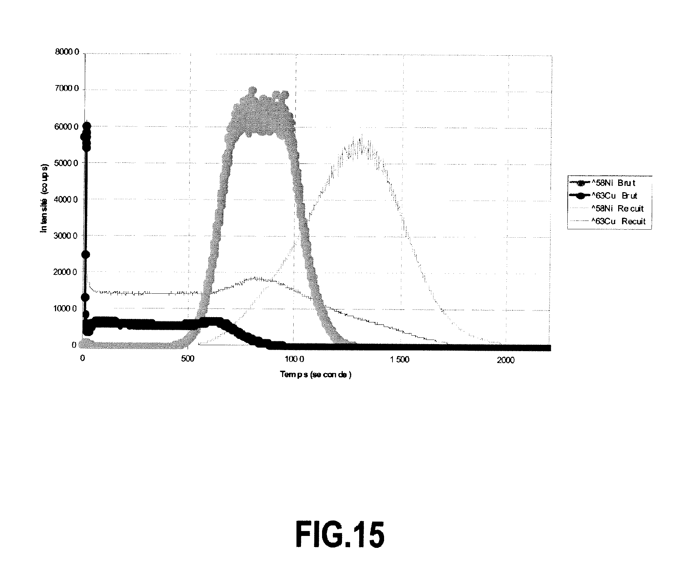

La comparaison des profils ToF-SIMS (voir figure 15) avant (échantillon brut) et après recuit à 400°C pendant deux heures sous atmosphère contrôlée montre l'absence de diffusion de cuivre dans la barrière de diffusion NiB.

### Exemple 11 - Réalisation d'un empilement isolant/barrière/couche de germination P4VP-PHEMA-NIB-Cu sur une surface de silicium dopé P de vias traversants.

### Substrat :

Le substrat utilisé dans cet exemple est constitué d'une plaque de silicium de 4 cm de côté (4 x 4 cm) et de 750 µm d'épaisseur ayant une résistivité comprise entre 3 Ω.cm et 26 Ω.cm, gravée avec des motifs cylindriques de type « via traversant » de 90 µm de profondeur et de 30 µm de diamètre.

### Isolation :

Réalisée selon l'exemple 3.

### Barrière de diffusion :

Réalisée selon l'exemple 8.

### Couche de germination :

Réalisée selon l'exemple 10.

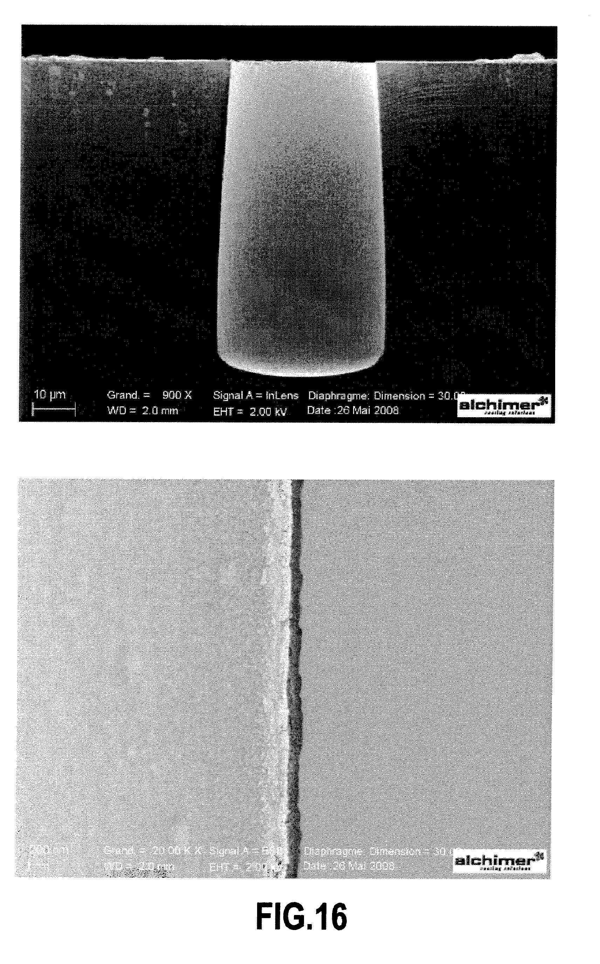

Une analyse en microscopie électronique à balayage (MEB) (voir **figure 16**) a permis de mettre en évidence l'empilement des trois couches isolant/barrière/cuivre sur la totalité de la surface du via.

### Exemple 12 - Réalisation d'un empilement isolant/barrière P4VP-NIB sur un substrat plan de silicium dopé P.

### Substrat :

Identique à celui utilisé dans l'exemple 2.

### Isolation :

Réalisée selon l'exemple 2.

### Barrière de diffusion :

Une barrière de Nickel-Bore (NiB) a été déposée en deux étapes sur la surface de poly-4-vinylpyridine obtenue à l'issue de l'étape d'isolation décrite dans l'exemple 2.

### Etape 1 : Activation de la surface de poly-4-vinylpyridine par un sel de palladium

### Solution :

La solution mise en oeuvre dans cet exemple est une solution aqueuse d'activation contenant 2 mg (1.10⁻⁵ mol) du sel commercial de chlorure de palladium PdCl₂ dissous dans 100 ml de HCl 0.1 M.

### Protocole :

Le substrat de silicium fonctionnalisé par la P4VP obtenu à l'exemple 2 a été immergé dans la solution d'activation pendant une durée comprise entre 30 secondes et 5 minutes, avant d'être lavé à l'eau dé-ionisée puis séché sous courant d'azote.

### Etape 2 : Formation d'une couche de nickel par dépôt electroless :

### Solution :

La solution de nickel est identique à celle utilisée dans l'exemple 7 à l'étape 3. Le pH de la solution a été ajusté à 9 par ajout d'éthanolamine.

### Protocole :

Identique à celui utilisé dans l'exemple 7 à l'étape 3.

### Caractérisations :

La surface ainsi traitée se caractérise par un aspect métallique uniforme (miroir). En fonction du temps de trempage dans la solution de nickel, les épaisseurs de nickel déposé sur le substrat peuvent varier entre quelques nanomètres et plusieurs centaines de nanomètres.

### Exemple 13 - Réalisation d'un empilement isolant/barrière/cuivre P4VP-NIB-Cu sur une surface de silicium dopé P de vias traversants

### Substrat :

Le substrat utilisé dans cet exemple est constitué d'une plaque de silicium de 4 cm de côté (4 cm x 4 cm) et de 750 µm d'épaisseur ayant une résistivité de 20 Ω.cm, gravée avec des motifs cylindriques de type « via traversant » de 30 µm de profondeur et de 5 µm de diamètre.

### Isolation :

Cette étape a été réalisée selon l'exemple 2.

### Barrière de diffusion :

Cette étape a été réalisée selon l'exemple 12. Afin de permettre une meilleure pénétration des différentes solutions dans les motifs de type « via traversant », les étapes 1 et 2 peuvent être effectuées sous ultrasons.

### Couche de germination de cuivre :

Cette étape a été réalisée selon l'exemple 10.

### Caractérisations :

Les pourcentages de conformité des couches de nickel et de cuivre, telles que déposées dans les motifs de type « via traversant » selon l'exemple 13, ont pu être mesurées à l'aide de coupes observées au microscope à balayage. Les valeurs obtenues sont de 78% dans le cas de la couche de nickel et de 60% dans le cas de la couche de cuivre.

## Revendications

1. Procédé de préparation d'un film isolant électrique à la surface d'un substrat conducteur ou semiconducteur de l'électricité, tel qu'un substrat de silicium, **caractérisé en ce qu'**il comprend :
a) la mise en contact de ladite surface avec une solution liquide exempte de tensioactif comprenant :
- un solvant protique ;
- au moins un sel de diazonium ;
- au moins un monomère polymérisable en chaîne et soluble dans ledit solvant protique ;
- au moins un acide en une quantité suffisante pour stabiliser ledit sel de diazonium par ajustement du pH de ladite solution à une valeur inférieure à 7, de préférence inférieure à 2,5 ;
b) la polarisation de ladite surface selon un mode potentio- ou galvano-pulsé pendant une durée suffisante pour former un film présentant une épaisseur d'au moins 60 nanomètres, et de préférence comprise entre 80 et 500 nanomètres.

2. Procédé selon la revendication 1, **caractérisé en ce que** le solvant protique est choisi dans le groupe constitué par l'eau, de préférence dé-ionisée ou distillée ; les solvants hydroxylés, en particulier les alcools ayant 1 à 4 atomes de carbone ; les acides carboxyliques ayant 2 à 4 atomes de carbone, en particulier l'acide formique et l'acide acétique et leurs mélanges.

3. Procédé selon la revendication 1 ou 2, **caractérisé en ce que** le sel de diazonium est un sel d'aryle de diazonium choisi dans les composés de formule (I) suivante :
R-N₂⁺,A⁻ (I)
dans laquelle :
- A réprésente un anion monovalent et
- R représente un groupe aryle.

4. Procédé selon l'une quelconque des revendications 1 à 3, **caractérisé en ce que** le monomère polymérisable en chaîne est soluble dans le solvant protique et choisi dans le groupe des monomères vinyliques choisis parmi les monomères de formule (II) suivante : 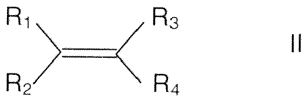 dans laquelle les groupes R₁ à R₄, identiques ou différents, représentent un atome monovalent non métallique tel qu'un atome d'halogène ou un atome d'hydrogène, ou un groupe chimique saturé ou insaturé, tel qu'un groupe alkyle en C₁-C₆, aryle, un groupe -COOR₅ dans lequel R₅ représente un atome d'hydrogène ou un groupe alkyle en C₁-C₆, nitrile, carbonyle, amine ou amide.

5. Procédé selon l'une quelconque des revendications 1 à 4, **caractérisé en ce que** la solution liquide précitée comprend :
- au moins 0.3 M de monomère(s) polymérisable(s),
- au moins 5.10⁻³ M de sel(s) de diazonium,
le rapport molaire entre le(s) monomère(s) polymérisable(s) et le(s) sel(s) de diazonium étant compris entre 10 et 300.

6. Procédé selon l'une quelconque des revendications 1 à 5, **caractérisé en ce que** la polarisation de ladite surface est réalisée selon un mode pulsé dont chaque cycle est **caractérisé par** :
- une période totale P comprise entre 10 ms et 2 s, de préférence de l'ordre de 0,6 s ;
- un temps de polarisation Tₒₙ compris entre 0,01 et 1 s, de préférence de l'ordre de 0,36 s durant lequel une différence de potentiel ou un courant est imposé à la surface du substrat ; et
- un temps de repos à potentiel ou courant nul d'une durée comprise entre 0,01 et 1 s, de préférence de l'ordre de 0,24 s.

7. Procédé de préparation d'un revêtement d'un substrat conducteur ou semiconducteur de l'électricité, tel qu'un substrat de silicium, ledit revêtement étant constitué d'une couche interne formant un film isolant électrique et d'une couche externe formant barrière de diffusion du cuivre, **caractérisé en ce que** :
A. ladite couche interne est réalisée par la mise en oeuvre du procédé selon l'une quelconque des revendications précédentes ;
B. ladite couche externe est réalisée par :
a) la formation par voie humide à la surface de la couche interne ainsi obtenue, d'un film organique contenant des particules, notamment des nanoparticules, de métaux ou d'alliages métalliques, en particulier de nickel ou de cobalt ;
b) la mise en contact du film ainsi formé avec une solution liquide contenant au moins un sel métallique, de préférence de même nature que le métal incorporé dans le film organique, un agent stabilisant et au moins un agent réducteur dans des conditions permettant la formation d'un film métallique présentant une épaisseur d'au moins 100 nanomètres.

8. Procédé selon la revendication 7, **caractérisé en ce que** l'étape B.a) précitée est réalisée dans des conditions non électrochimiques par la mise en contact de la surface libre de la couche interne précitée avec une solution liquide comprenant :
- au moins un solvant, de préférence protique,
- au moins un sel de diazonium ;
- au moins un monomère polymérisable en chaîne par voie radicalaire et soluble dans ledit solvant ;
- au moins un amorceur chimique permettant la formation d'entités radicalaires à partir dudit sel de diazonium.

9. Procédé selon l'une des revendications 7 ou 8, **caractérisé en ce que** le monomère polymérisable en chaîne utilisé à l'étape A.a) est une vinylpyridine, de préférence la 4-vinylpyridine, ou un méthacrylate, de préférence le 2-hydroxyéthyl méthacrylate, et **en ce que** le monomère polymérisable en chaîne par voie radicalaire utilisé à l'étape B.a) est le 2-hydroxyéthyl méthacrylate.

10. Procédé selon l'une des revendications 8 ou 9, **caractérisé en ce que** l'amorceur chimique précité est choisi parmi un métal réducteur sous forme finement divisée ou une base organique ou inorganique dans des proportions suffisantes pour que le pH de la solution liquide soit supérieur ou égal à 4.

11. Procédé selon la revendication 7, **caractérisé en ce que** le monomère polymérisable en chaîne utilisé à l'étape A.a) est une vinylpyridine, de préférence la 4-vinylpyridine et **en ce que** l'étape B.a) est réalisée par la mise en contact de la surface libre de la couche interne de polyvinylpyridine avec une solution liquide comprenant :
- au moins un solvant, de préférence protique ;
- au moins un polymère soluble dans ledit solvant et comportant des groupes fonctionnels susceptibles de se lier par liaisons hydrogène ou de Van der Waals avec les groupes fonctionnels de la polyvinylpyridine ; ledit polymère étant choisi parmi les polymères contenant une ou plusieurs fonctions choisie(s) parmi les fonctions hydroxyle, amine (primaire ou secondaire), ammonium, acide carboxylique, sels d'acide carboxylique, anhydride carboxylique (cyclique ou linéaire), amide : C(=O)NHR où R représente un atome d'hydrogène ou un groupe alkyle ayant 1 à 6 atomes de carbone, amino-acide, acide phosphonique, sels d'acide phosphonique, acide phosphorique, sels d'acide phosphorique, acide sulfonique, sels d'acide sulfonique, acide sulfurique, sels d'acide sulfurique, acide succinimique, sels d'acide succinimique, phtalimide, sels de phtalimide, Si(OH)ₙ où n est un nombre entier compris entre 1 et 3 ;
pendant une durée suffisante pour permettre la formation desdites liaisons hydrogène ou de Van der Waals.

12. Procédé selon la revendication 11, **caractérisé en ce que** le monomère polymérisable en chaîne utilisé à l'étape A.a) est la 4-vinylpyridine et **en ce que** le polymère soluble utilisé à l'étape B.a) est un polyacide acrylique.

13. Procédé selon l'une quelconque des revendications 7 à 12, **caractérisé en ce que** le sel métallique précité est choisi dans le groupe constitué par l'acétate, l'acétylacétonate, l'hexafluorophosphate, le nitrate, le perchlorate, le sulfate, ou le tétrafluoroborate du métal précité.

14. Procédé selon l'une quelconque des revendications 7 à 13, **caractérisé en ce que** l'agent réducteur précité est choisi dans le groupe constitué par l'acide hypophosphoreux et ses sels, les dérivés du borane (NaBH₄, DMAB), le glucose, le formaldéhyde et l'hydrazine.

15. Procédé de préparation d'un revêtement d'un substrat conducteur ou semiconducteur de l'électricité, tel qu'un substrat de silicium, selon l'une quelconque des revendications 7 à 14 ; **caractérisé en ce qu'**il comprend en outre la réalisation d'une couche externe par :
C. a) la mise en contact de la surface libre de la couche intermédiaire avec une solution liquide comprenant :
- au moins un solvant ;
- des ions de cuivre en une concentration comprise entre 14 et 120 mM ;
- de l'éthylènediamine ;
- le rapport molaire entre l'éthylènediamine et le cuivre étant compris entre 1,80 et 2,03 ;
- le pH de ladite composition étant compris entre 6,6 et 7,5 ;
b) la polarisation de ladite surface libre de la deuxième couche pendant une durée suffisante pour former ladite couche externe.

16. Procédé selon la revendication 15, **caractérisé en ce que** la solution liquide utilisée à l'étape C.a) précitée comprend des ions cuivriques provenant de sulfate de cuivre en une quantité comprise entre 16 et 64 mM et **en ce que** le rapport molaire entre l'éthylènediamine et les ions du cuivre est compris entre 1,96 et 2,0.

17. Tranche d'un matériau conducteur ou semiconducteur, notamment en silicium, comportant un ou plusieurs vias, **caractérisée en ce que** les parois de chaque via sont recouvertes d'une couche interne en poly-4-vinylpyridine d'une épaisseur comprise entre 200 et 400 nanomètres formant isolant électrique, déposée selon le procédé d'une des revendications précédentes, elle-même recouverte d'une couche de nickel éventuellement allié au bore, d'une épaisseur comprise entre 100 et 300 nanomètres formant barrière de diffusion au cuivre, elle-même recouverte d'une couche de cuivre d'une épaisseur comprise entre 200 et 500 nanomètres formant couche de germination.

18. Tranche d'un matériau conducteur ou semiconducteur, notamment en silicium, comportant un ou plusieurs vias, **caractérisée en ce que** les parois de chaque via sont recouvertes d'une couche interne en poly-2-hydroxyéthyl méthacrylate d'une épaisseur comprise entre 200 et 400 nanomètres formant isolant électrique, déposée selon le procédé d'une des revendications précédentes,
elle-même recouverte d'une couche de nickel éventuellement alliée au bore, d'une épaisseur comprise entre 100 et 300 nanomètres formant barrière de diffusion au cuivre, elle-même recouverte d'une couche de cuivre d'une épaisseur comprise entre 200 et 500 nanomètres formant couche de germination.

## Patentansprüche

1. Verfahren zur Herstellung eines elektrisch isolierenden Films auf der Oberfläche eines die Elektrizität leitenden oder halbleitenden Substrats, wie eines Siliziumsubstrats, **dadurch gekennzeichnet, dass** es umfasst:
a) das Inkontaktbringen der Oberfläche mit einer flüssigen, Tensid-freien Lösung, die umfasst:
- ein protisches Lösungsmittel,
- wenigstens ein Diazoniumsalz,
- wenigstens ein kettenpolymerisierbares und in dem protischen Lösungsmittel lösliches Monomer,
- wenigstens eine Säure in einer ausreichenden Menge, um das Diazoniumsalz durch Einstellen des pH-Wertes der Lösung auf einen Wert von unter 7, vorzugsweise von unter 2,5, zu stabilisieren,
b) das Polarisieren der Oberfläche in einem potential- oder galvano-gepulsten Modus für eine ausreichende Zeitdauer, um einen Film zu bilden, der eine Dicke von wenigstens 60 Nanometern und vorzugsweise zwischen 80 und 500 Nanometern aufweist.

2. Verfahren nach Anspruch 1, **dadurch gekennzeichnet, dass** das protische Lösungsmittel aus der Gruppe bestehend aus Wasser, vorzugsweise entionisiertem oder destilliertem, den hydroxylierten Lösungsmitteln, insbesondere den Alkoholen mit 1 bis 4 Kohlenstoffatomen, den Carbonsäuren mit 2 bis 4 Kohlenstoffatomen, insbesondere der Ameisensäure und der Essigsäure, sowie ihren Mischungen ausgewählt ist.

3. Verfahren nach Anspruch 1 oder 2, **dadurch gekennzeichnet, dass** das Diazoniumsalz ein Aryldiazonium-Salz ist, das aus den Verbindungen der folgenden Formel (I) ausgewählt ist:
R-N₂⁺,A⁻ (I)
worin:
- A ein einwertiges Anion darstellt und
- R eine Arylgruppe darstellt.

4. Verfahren nach einem der Ansprüche 1 bis 3, **dadurch gekennzeichnet, dass** das kettenpolymerisierbare Monomer in dem protischen Lösungsmittel löslich ist und ausgewählt ist aus der Gruppe der Vinylmonomere, die aus den Monomeren der folgenden Formel (II) ausgewählt sind: 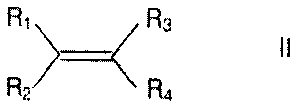 worin die Gruppen R₁ bis R₄, die identisch oder unterschiedlich sind, ein einwertiges, nicht metallisches Atom, wie ein Halogenatom oder ein Wasserstoffatom, oder eine gesättigte oder ungesättigte chemische Gruppe, wie eine C₁-C₆-Alkyl-, Aryl-Gruppe, eine -COOR₅-Gruppe, worin R₅ ein Wasserstoffatom darstellt, oder eine C₁-C₆-Alkyl-, Nitril-, Carbonyl-, Amino- oder Amidgruppe darstellen.

5. Verfahren nach einem der Ansprüche 1 bis 4, **dadurch gekennzeichnet, dass** die vorgenannte flüssige Lösung umfasst:
- wenigstens 0.3 M polymerisierbare(s) Monomer(e),
- wenigstens 5.10⁻³ M Diazoniumsalz(e),
wobei das Molverhältnis zwischen dem (den) polymerisierbaren Monomer(en) und dem (den) Diazoniumsalz(en) zwischen 10 und 300 beträgt.

6. Verfahren nach einem der Ansprüche 1 bis 5, **dadurch gekennzeichnet, dass** die Polarisation der Oberfläche in einem gepulsten Modus durchgeführt wird, von dem jeder Zyklus **gekennzeichnet ist durch**:
- eine Gesamtperiode P zwischen 10 ms und 2 s, vorzugsweise in der Größenordnung von 0,6 s,
- eine Polarisationszeit Tₒₙ zwischen 0,01 und 1 s, vorzugsweise in der Größenordnung von 0,36 s, während derer der Oberfläche des Substrats eine Potentialdifferenz oder ein Strom auferlegt wird, und
- eine Ruhezeit mit einem Potential oder Strom Null, mit einer Dauer zwischen 0,01 und 1 s, vorzugsweise in der Größenordnung von 0,24 s.

7. Verfahren zur Herstellung einer Beschichtung eines die Elektrizität leitenden oder halbleitenden Substrats, wie eines Siliziumsubstrats, wobei die Beschichtung aus einer Innenschicht, die einen elektrisch isolierenden Film bildet, und aus einer Außenschicht, die eine Kupfer-Diffusionsbarriere bildet, besteht, **dadurch gekennzeichnet, dass**:
A. die Innenschicht durch die Anwendung des Verfahrens nach einem der vorhergehenden Ansprüche ausgebildet wird,
B. die Außenschicht ausgebildet wird durch:
a) die Bildung im Nassverfahren, auf der Oberfläche der so erhaltenen Innenschicht, eines organischen Films, der Partikel, insbesondere Nanopartikel, aus Metallen oder Metalllegierungen, insbesondere aus Nickel oder aus Kobalt, enthält,
b) das Inkontaktbringen des so gebildeten Films mit einer flüssigen Lösung, die wenigstens ein Metallsalz, vorzugsweise von der gleichen Art wie das in den organischen Film eingebettete Metall, einen Stabilisator und wenigstens ein Reduktionsmittel unter Bedingungen, die die Bildung eines Metallfilms mit einer Dicke von wenigstens 100 Nanometern ermöglichen, enthält.

8. Verfahren nach Anspruch 7, **dadurch gekennzeichnet, dass** der vorgenannte Schritt B.a) unter nicht elektrochemischen Bedingungen durch Inkontaktbringen der freien Fläche der vorgenannten Innenschicht mit einer flüssigen Lösung durchgeführt wird, die umfasst:
- wenigstens ein vorzugsweise protisches Lösungsmittel,
- wenigstens ein Diazoniumsalz,
- wenigstens ein Monomer, das auf radikalischem Weg kettenpolymerisierbar und in dem Lösungsmittel löslich ist,
- wenigstens einen chemischen Initiator, der die Bildung von radikalischen Einheiten mittels des Diazoniumsalzes ermöglicht.

9. Verfahren nach einem der Ansprüche 7 oder 8, **dadurch gekennzeichnet, dass** das bei Schritt A.a) verwendete kettenpolymerisierbare Monomer ein Vinylpyridin, vorzugsweise 4-Vinylpyridin, oder ein Methacrylat, vorzugsweise 2-Hydroxyethylmethacrylat, ist und dass das bei Schritt B.a) verwendete auf radikalischem Weg kettenpolymerisierbare Monomer 2-Hydroxyethylmethacrylat ist.

10. Verfahren nach einem der Ansprüche 8 oder 9, **dadurch gekennzeichnet, dass** der vorgenannte chemische Initiator aus einem Reduktionsmetall in fein verteilter Form oder einer organischen oder anorganischen Base in ausreichenden Anteilen, damit der pH-Wert der flüssigen Lösung größer als oder gleich 4 ist, ausgewählt ist.

11. Verfahren nach Anspruch 7, **dadurch gekennzeichnet, dass** das bei Schritt A.a) verwendete kettenpolymerisierbare Monomer ein Vinylpyridin, vorzugsweise 4-Vinylpyridin ist und dass der Schritt B.a) durch Inkontaktbringen der freien Fläche der Innenschicht aus Polyvinylpyridin mit einer flüssigen Lösung durchgeführt wird, die umfasst:
- wenigstens ein vorzugswiese protisches Lösungsmittel,
- wenigstens ein Polymer, das in dem Lösungsmittel löslich ist und das funktionelle Gruppen umfasst, die geeignet sind, sich durch Wasserstoff- oder Van-der-Waals-Bindungen mit den funktionellen Gruppen des Polyvinylpyridin zu verbinden, wobei das Polymer aus den Polymeren ausgewählt ist, die eine oder mehrere Funktionen enthalten, welche ausgewählt ist (sind) aus den Funktionen Hydroxyl-, (primäre oder sekundäre) Amino-, Ammonium-, Carbonsäure, Carbonsäuresalze, (zyklische oder lineare) Carboxyanhydrid-, Amid-: C(=0)NHR, worin R ein Wasserstoffatom oder eine Alkylgruppe mit 1 bis 6 Kohlenstoffatomen darstellt, Aminosäure, Phosphonsäure, Phosphonsäuresalze, Phosphorsäure, Phosphorsäuresalze, Sulfonsäure, Sulfonsäuresalze, Schwefelsäure, Schwefelsäuresalze, Succiniminsäure, Succiniminsäuresalze, Phthalimid, Phthalimidsalze, Si(OH)ₙ, worin n eine ganze Zahl zwischen 1 und 3 ist,
für eine Zeitdauer, die ausreichend ist, um die Bildung der Wasserstoff- oder Van-der-Waals-Bindungen zu ermöglichen.

12. Verfahren nach Anspruch 11, **dadurch gekennzeichnet, dass** das bei Schritt A.a) verwendete kettenpolymerisierbare Monomer 4-Vinylpyridin ist und dass das bei Schritt B.a) verwendete lösliche Polymer eine Polyacrylsäure ist.

13. Verfahren nach einem der Ansprüche 7 bis 12, **dadurch gekennzeichnet, dass** das vorgenannte Metallsalz aus der Gruppe bestehend aus Acetat, Acetylacetonat, Hexafluorophosphat, Nitrat, Perchlorat, Sulfat, oder Tetrafluoroborat des vorgenannten Metalls ausgewählt ist.

14. Verfahren nach einem der Ansprüche 7 bis 13, **dadurch gekennzeichnet, dass** das vorgenannte Reduktionsmittel aus der Gruppe bestehend aus hypophosphoriger Säure, und ihren Salzen, den Derivaten von Boran (NaBH₄, DMAB), Glucose, Formaldehyd und Hydrazin ausgewählt ist.

15. Verfahren zur Herstellung einer Beschichtung eines die Elektrizität leitenden oder halbleitenden Substrats, wie eines Siliziumsubstrats, nach einem der Ansprüche 7 bis 14, **dadurch gekennzeichnet, dass** es ferner die Ausbildung einer Außenschicht umfasst durch:
C. a) das Inkontaktbringen der freien Fläche der Zwischenschicht mit einer flüssigen Lösung, die umfasst:
- wenigstens ein Lösungsmittel,
- Kupferionen in einer Konzentration zwischen 14 und 120 mM,
- Ethylendiamin,
- wobei das Molverhältnis zwischen dem Ethylendiamin und dem Kupfer zwischen 1,80 und 2,03 beträgt,
- wobei der pH-Wert der Zusammensetzung zwischen 6,6 und 7,5 beträgt,
b) das Polarisieren der freien Fläche der zweiten Schicht über eine ausreichende Zeitdauer, um die Außenschicht zu bilden.

16. Verfahren nach Anspruch 15, **dadurch gekennzeichnet, dass** die bei dem vorgenannten Schritt C.a) verwendete flüssige Lösung aus Kupfersulfat stammende Kupfer(11)-Ionen in einer Menge zwischen 16 und 64 mM umfasst und dass das Molverhältnis zwischen dem Ethylendiamin und den Kupferionen zwischen 1,96 und 2,0 beträgt.

17. Wafer aus einem leitenden oder Halbleiter-Werkstoff, insbesondere aus Silizium, umfassend eine oder mehrere Vias, **dadurch gekennzeichnet, dass** die Wände einer jeden Via mit einer einen elektrischen Isolator bildenden Innenschicht aus Poly-4-vinylpryidin mit einer Dicke zwischen 200 und 400 Nanometern, die nach dem Verfahren von einem der vorhergehenden Ansprüche abgeschieden ist, überzogen sind, die selbst mit einer eine Kupfer-Diffusionsbarriere bildenden Schicht aus Nickel, eventuell mit Bor legiert, mit einer Dicke zwischen 100 und 300 Nanometern überzogen ist, die selbst mit einer Kupferschicht mit einer Dicke zwischen 200 und 500 Nanometern, welche eine Keimschicht bildet, überzogen ist.

18. Wafer aus einem leitenden oder Halbleiter-Werkstoff, insbesondere aus Silizium, umfassend eine oder mehrere Vias, **dadurch gekennzeichnet, dass** die Wände einer jeden Via mit einer einen elektrischen Isolator bildenden Innenschicht aus Poly-2-hydroxyethylmethacrylat mit einer Dicke zwischen 200 und 400 Nanometern, die nach dem Verfahren von einem der vorhergehenden Ansprüche abgeschieden ist, überzogen sind, die selbst mit einer eine Kupfer-Diffusionsbarriere bildenden Schicht aus Nickel, eventuell mit Bor legiert, mit einer Dicke zwischen 100 und 300 Nanometern überzogen ist, die selbst mit einer Kupferschicht mit einer Dicke zwischen 200 und 500 Nanometern, welche eine Keimschicht bildet, überzogen ist.

## Claims

1. Method of preparing an electrically insulating film at the surface of an electrical conductor or semiconductor substrate, such as a silicon substrate, **characterized in that** it comprises:
a) bringing said surface into contact with a liquid solution comprising no surfactant, and comprising:
- a protic solvent;
- at least one diazonium salt;
- at least one monomer that is chain-polymerizable and soluble in said protic solvent;
- at least one acid in a sufficient quantity to stabilize said diazonium salt by adjusting the pH of said solution to a value less than 7, preferably less than 2.5;
b) the polarization of said surface according to a potentio- or galvano-pulsed mode for a duration sufficient to form a film having a thickness of at least 60 nanometres, and preferably between 80 and 500 nanometres.

2. Method according to Claim 1, **characterized in that** the protic solvent is chosen from the group consisting of water, preferably deionized or distilled water; hydroxylated solvents, in particular alcohols having 1 to 4 carbon atoms; carboxylic acids having 2 to 4 carbon atoms, in particular formic acid and acetic acid, and mixtures thereof.

3. Method according to Claim 1 or 2, **characterized in that** the diazonium salt is an aryldiazonium salt chosen from the compounds of the following formula (I):
R-N₂⁺,A⁻ (I)
in which:
- A represents a monovalent anion,
- R represents an aryl group.

4. Method according to any one of Claims 1 to 3, **characterized in that** the chain-polymerizable monomer is soluble in the protic solvent and is chosen from the group of vinyl monomers chosen from the monomers of the following formula (II): 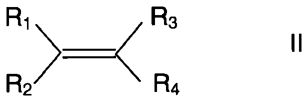 in which the, identical or different, groups R₁ to R₄ represent a monovalent non-metal atom such as a halogen atom or a hydrogen atom, or a saturated or unsaturated chemical group such as a C₁-C₆ alkyl or aryl, a -COOR₅ group in which R₅ represents a hydrogen atom or a C₁-C₆ alkyl, nitrile, carbonyl, amine or amide group.

5. Method according to any one of Claims 1 to 4, **characterized in that** the aforementioned liquid solution comprises:
- at least 0.3M of polymerizable monomer(s),
- at least 5×10⁻³M of diazonium salt(s),
the molar ratio of the polymerizable monomer(s) to the diazonium salt(s) being between 10 and 300.

6. Method according to any one of Claims 1 to 5, **characterized in that** the polarization of said surface is produced in a pulsed mode, each cycle of which is **characterized by**:
- a total period P of between 10 ms and 2 s, preferably of around 0.6 s;
- a polarization time Tₒₙ of between 0.01 and 1 s, preferably around 0.36 s, during which a potential difference or a current is applied to the surface of the substrate; and
- an idle period with zero potential or current of a duration of between 0.01 and 1 s, preferably of around 0.24 s.

7. Method of preparing a coating of an electrical conductor or semiconductor substrate, such as a silicon substrate, said coating consisting of an internal layer forming an electrically insulating film and an external layer forming a copper diffusion barrier, **characterized in that**:
A. said internal layer is produced by employing the method according to any one of the preceding claims;
B. said external layer is produced by:
a) the formation by wet process, at the surface of the internal layer thus obtained, of an organic film containing particles, especially nanoparticles, of metals or metal alloys, in particular of nickel or cobalt;
b) bringing the film thus formed into contact with a liquid solution containing at least one metal salt, preferably of the same nature as the metal incorporated into the organic film, a stabilizing agent, and at least one reducing agent under conditions enabling the formation of a metal film having a thickness of at least 100 nm.

8. Method according to Claim 7, **characterized in that** the aforementioned step B.a) is carried out in non-electrochemical conditions by bringing the free surface of the aforementioned internal layer into contact with a liquid solution containing:
- at least one solvent, preferably a protic solvent;
- at least one diazonium salt;
- at least one monomer that is chain-polymerizable by free radical methods and soluble in said solvent; and
- at least one chemical initiator enabling the formation of radical entities from said diazonium salt.

9. Method according to either of Claims 7 or 8, **characterized in that** the chain-polymerizable monomer used in step A.a) is a vinylpyridine, preferably 4-vinylpyridine, or a methacrylate, preferably 2-hydroxyethyl methacrylate, and **in that** the monomer which is chain-polymerizable by free radical methods used in step B.a) is 2-hydroxyethyl methacrylate.

10. Method according to one of Claims 8 or 9, **characterized in that** the aforementioned chemical initiator is chosen from a metal reducing agent in finely divided form or an organic or inorganic base in sufficient proportions for the pH of the liquid solution to be greater than or equal to 4.

11. Method according to Claim 7, **characterized in that** the chain-polymerizable monomer used in step A.a) is a vinylpyridine, preferably 4-vinylpyridine and **in that** step B.a) is carried out by bringing the free surface of the internal layer of polyvinylpyridine into contact with a liquid solution comprising:
- at least one solvent, preferably a protic solvent;
- at least one polymer that is soluble in said solvent and comprising functional groups capable of bonding with the functional groups of the polyvinylpyridine by hydrogen bonds or Van der Waals bonds, said polymer being chosen from the polymers containing one or more functional groups chosen from the following functional groups: hydroxyl, (primary or secondary) amine, ammonium, carboxylic acid, carboxylic acid salts, (cyclic or linear) carboxylic anhydride, amide: C(=O)NHR where R represents a hydrogen atom or an alkyl group having 1 to 6 carbon atoms, an amino acid, phosphonic acid, phosphonic acid salts, phosphoric acid, phosphoric acid salts, sulphonic acid, sulphonic acid salts, sulphuric acid, sulphuric acid salts, succinamic acid, succinamic acid salts, phthalimide, phthalimide salts, Si(OH)ₙ where n is an integer between 1 and 3; for a sufficient duration to enable the formation of said hydrogen or Van der Waals bonds.

12. Method according to Claim 11, **characterized in that** the chain-polymerizable monomer used in step A.a) is 4-vinylpyridine and **in that** the soluble polymer used in step B.a) is an acrylic polyacid.

13. Method according to any one of Claims 7 to 12, **characterized in that** the aforementioned metal salt is chosen from the group consisting of the acetate, acetylacetonate, hexafluorophosphate, nitrate, perchlorate, sulphate or tetrafluoroborate of the aforementioned metal.

14. Method according to any one of Claims 7 to 13, **characterized in that** the aforementioned reducing agent is chosen from the group consisting of hypophosphorous acid and its salts, borane derivatives (NaBH₄, DMAB), glucose, formaldehyde and hydrazine.

15. Method of preparing a coating of an electrical conductor or semiconductor substrate, such as a silicon substrate, according to any one of Claims 7 to 14; **characterized in that** the method comprises making an external layer produced by:
C. a) bringing the free surface of the intermediate layer into contact with a liquid solution comprising:
- at least one solvent;
- copper ions in a concentration of between 14 and 120mM;
- ethylenediamine;
- the molar ratio of ethylenediamine to copper being between 1.80 and 2.03;
- the pH of said composition being between 6.6 and 7.5;
b) polarization of said free surface of the second layer for a sufficient duration to form said external layer.

16. Method according to Claim 15, **characterized in that** the liquid solution used in the aforementioned step C.a) comprises cupric ions coming from copper sulphate in an amount between 16 and 64 mM and **in that** the molar ratio of ethylenediamine to the copper ions is between 1.96 and 2.0.

17. Wafer of a conductor or semiconductor material, especially made of silicon, comprising one or more vias, **characterized in that** the walls of each via are covered with an internal layer made of poly-4-vinylpyridine with a thickness of between 200 and 400 nanometres forming an electrical insulator, being deposited according to the method of any one of preceding claims; which is itself coated with a layer of nickel, optionally alloyed with boron, with a thickness of between 100 and 300 nanometres forming a copper diffusion barrier, which is itself covered with a copper layer with a thickness of between 200 and 500 nanometres forming a seed layer.

18. Wafer of a conductor or semiconductor material, especially made of silicon, comprising one or more vias, **characterized in that** the walls of each via are covered with an internal layer made of poly-2-hydroxyethyl methacrylate with a thickness of between 200 and 400 nanometres forming an electrical insulator, being deposited according to the method of any one of preceding claims; which is itself coated with a layer of nickel, optionally alloyed with boron, with a thickness of between 100 and 300 nanometres forming a copper diffusion barrier, which is itself covered with a copper layer with a thickness of between 200 and 500 nanometres forming a seed layer.
